# FASCICULE DE BREVET EUROPEEN

(11) **EP 4 577 030 B1**
(45) Date de publication et mention de la délivrance du brevet: **01.04.2026**
(21) Numéro de dépôt: 24221919.4
(22) Date de dépôt: 19.12.2024
(51) Int. Cl.: H10N 70/20

(54) **DISPOSITIF MÉMOIRE À CHANGEMENT DE PHASE À TENUE EN TEMPÉRATURE AMÉLIORÉE ET PROCÉDÉ**
PHASENWECHSELSPEICHERVORRICHTUNG MIT VERBESSERTER TEMPERATURBESTÄNDIGKEIT UND VERFAHREN
PHASE-CHANGE MEMORY DEVICE WITH IMPROVED TEMPERATURE RESISTANCE AND PROCESS

(30) Priorité: 21.12.2023 FR 2314750
(43) Date de publication de la demande: 25.06.2025
(73) Titulaire: Commissariat à l'Energie Atomique et aux Energies Alternatives, 75015 Paris (FR)
(72) Inventeur: DORY, Jean-Baptiste, 38054 Grenoble Cedex 09 (FR); BOURGEOIS, Guillaume, 38054 Grenoble Cedex 09 (FR)
(74) Mandataire: Hautier IP

(56) Documents cités:
- US-A1- 2011 057 161
- US-A1- 2011 155 986
- US-A1- 2013 175 493
- US-A1- 2023 093 026

## Description

### DOMAINE TECHNIQUE

La présente invention concerne le domaine des dispositifs mémoires à changement de phase. Elle trouve comme application particulièrement avantageuse les dispositifs mémoires dont l'architecture des points mémoires inclut un élément chauffant sous-jacent à la couche mémoire.

### ETAT DE LA TECHNIQUE

Les dispositifs mémoires représentent des enjeux cruciaux dans de nombreuses applications, par exemples pour le type de mémoire communément désignée par le terme anglais Storage Class Memory (SCM), les mémoires embarquées pour l'automobile, ou les applications neuromorphiques. Dans ce contexte, les mémoires résistives représentent de très bons candidats pour supporter ou remplacer la mémoire Flash. Les mémoires résistives présentent en effet des avantages significatifs en termes de vitesse et de mise à l'échelle, c'est-à-dire la réduction des dimensions de la cellule unitaire mémoire, et de la distance entre deux points mémoires, ce qui a pour effet d'augmenter la densité de points mémoires dans les matrices de mémoire. Parmi les mémoires résistives, les mémoires à changement de phase (communément abrégées PCM, de l'anglais Phase Change Memory) représentent la technologie de mémoire résistive non volatile parmi les plus mûres et à un stade de développement et de production avancé.

Les mémoires à changement de phase comprennent typiquement deux états de programmation obtenus à partir d'une couche à base d'un matériau à changement de phase formant une couche dite « mémoire » et présentant un état amorphe et un état cristallin :
a. programmation « RESET » ou de façon équivalente HRS, de l'anglais High Resistive State (que l'on peut traduire par état de haute résistivité), qui se base sur la fonte de la totalité ou d'une partie de la couche chalcogénure, lors d'une impulsion électrique permettant d'atteindre la température de fusion du matériau par effet Joule. La partie fondue du matériau chalcogénure est ensuite figée dans un état amorphe par refroidissement soudain, obtenu par réduction rapide du courant. L'état amorphe du matériau chalcogénure est très peu conducteur électriquement. La programmation reset permet de stocker l'information « 0 », avec le stockage d'une résistance élevée dans le dispositif PCM.
b. programmation « SET » ou de façon équivalente LRS, de l'anglais Low Resistive State (que l'on peut traduire par état de faible résistivité), qui se base sur une fonte partielle ou totale du matériau chalcogénure lors d'une impulsion électrique. Le matériau chalcogénure est ensuite cristallisé par un refroidissement graduel obtenu par réduction graduelle du courant. L'état cristallin du matériau chalcogénure est un meilleur conducteur électrique que l'état amorphe. La programmation set permet de stocker l'information « 1 », avec le stockage d'une résistance faible dans le dispositif PCM.

Le travail d'optimisation des mémoires de ce type est aujourd'hui porté entre autres sur la diminution de la dérive de l'état « SET » et sur la réduction de la taille du point mémoire. Cependant, l'extension verticale de la cellule PCM unitaire est un paramètre non négligeable compte tenu de son impact sur la résistance passive des connections métalliques verticales dans les via métalliques des dispositifs intégrés au même niveau. Dans l'intégration des cellules PCM la plus répandue, une part importante de la dimension verticale de la cellule PCM correspond à l'élément chauffant (couramment désigné par le terme anglais de « heater ») se trouvant sous le matériau à changement de phase. Cet élément chauffant est au cœur du fonctionnement de la cellule PCM : lorsqu'il est parcouru par un courant, il émet par effet Joule de la chaleur se propageant dans la couche mémoire et modifiant l'état du matériau à changement de phase. En fonction de la quantité de chaleur émise par l'élément chauffant, la couche mémoire passe de l'état « SET » à l'état « RESET », ou inversement.

Les performances de l'élément résistif chauffant sont tout d'abord très sensibles à ses dimensions. Notamment, on préfère un élément chauffant assez fin (quelques nanomètres ou dizaines de nanomètres d'épaisseur) afin de maximiser l'effet Joule ayant lieu en son sein. De la sorte, on améliore le contrôle de l'état de la couche mémoire et donc les performances du dispositif.

Les performances de l'élément résistif chauffant sont par ailleurs très sensibles aux propriétés du matériau qui le compose. Or, les procédés de dépôt permettant de réaliser l'élément chauffant aux dimensions préférentielles mentionnées précédemment (dépôt chimique en phase vapeur, dépôt chimique par flux alterné) imposent des limites en termes de composition de l'élément chauffant. Cela est dû à différents paramètres, notamment les précurseurs utilisés, la réactivité des éléments en jeu ou encore la température à laquelle doivent être réalisés ces procédés de dépôt. Ainsi, la gamme des matériaux envisageables pour l'élément chauffant est restreinte, et ces derniers ne présentent pas les propriétés physiques les plus avantageuses pour le fonctionnement du point mémoire. Notamment, les matériaux pouvant être déposés par les procédés cités plus haut ne présentent pas une stabilité optimale aux températures de fonctionnement du point mémoire. Ainsi, il existe un besoin d'amélioration des propriétés thermiques du point mémoire, tout en conservant un élément chauffant ayant des dimensions favorisant les performances du dispositif. Les documents US 2011/0057161, US 2023/0093026, US 2013/0175493 et US2011/0155986 divulguent des exemples d'un dispositif mémoire à changement de phase.

### RESUME

Pour atteindre cet objectif, un premier aspect de l'invention concerne un dispositif mémoire à changement de phase comprenant un point mémoire, le point mémoire comprenant :
a. une couche métallique à base d'un matériau métallique et formant un élément chauffant,
b. une couche mémoire à base d'un matériau à changement de phase, le matériau à changement de phase étant configuré de sorte que la couche mémoire passe sélectivement d'un premier état résistif (LRS) présentant une première résistivité à un deuxième état résistif (HRS) présentant une deuxième résistivité supérieure à la première résistivité,
c. une électrode supérieure.

L'élément chauffant est destiné à recevoir un courant électrique permettant de produire de la chaleur par effet Joule et à transférer une partie de cette chaleur à la couche mémoire de sorte à faire passer sélectivement la couche mémoire de l'un parmi le premier état résistif (LRS) et le deuxième état résistif (HRS) vers l'autre parmi le premier état résistif (LRS) et le deuxième état résistif (HRS). Selon un mode de réalisation, l'élément chauffant peut également faire passer sélectivement la couche mémoire du premier état résistif (LRS) ou du deuxième état résistif (HRS) vers un troisième état résistif présentant une troisième résistivité, différente de la première résistivité et de la troisième résistivité, et inversement. De façon générale, l'élément chauffant peut être configuré pour pouvoir faire placer sélectivement la couche mémoire dans N niveaux, avec N un entier supérieur ou égal à 2, chaque niveau se caractérisant par une résistivité différente. Lorsque N est strictement supérieur à 2, le dispositif mémoire est qualifié de multiniveau et permet de coder plus d'informations au niveau d'un même point mémoire. Cela peut par exemple permettre de fabriquer des réseaux de neurones artificiels.

L'élément chauffant présente un premier flanc principal et un deuxième flanc principal, opposés l'un à l'autre.

Le dispositif mémoire comprend en outre une première couche d'encapsulation s'étendant depuis le premier flanc principal de la couche métallique. La première couche d'encapsulation présente une portion, dite dopée, présentant un dopage à base d'au moins une espèce, dite première espèce dopante, la portion dopée s'étendant depuis le premier flanc principal de la couche métallique. La couche métallique présente un dopage à base d'une deuxième espèce dopante, de préférence identique à la première espèce dopante.

Le dopage de la première couche d'encapsulation permet d'améliorer la résistivité thermique du point mémoire. Notamment, ce dopage permet de réduire la valeur du coefficient de transfert thermique de la première couche d'encapsulation, ce qui permet un certain confinement thermique de l'élément chauffant, moins de dissipation de la chaleur depuis l'élément chauffant vers les régions du dispositif autres que la couche mémoire, et donc une réduction de l'énergie nécessaire pour la programmation de l'état « **RESET** ». Le dopage de la première couche d'encapsulation permet ainsi d'utiliser des matériaux autorisant la formation d'une couche mémoire aux dimensions avantageuses telles que mentionnées précédemment, tout en garantissant un très bon ratio entre l'énergie utilisée pour chauffer l'élément chauffant et l'énergie effectivement transmise à la couche mémoire. L'invention permet donc d'atteindre l'objectif visé plus haut, à savoir améliorer les propriétés thermiques du point mémoire, ce qui conduit à une amélioration de ses performances. L'effet de confinement thermique de l'élément chauffant est par ailleurs encore amélioré lorsque le dispositif comprend une deuxième couche d'encapsulation, elle aussi dopée.

La présence de la première couche d'encapsulation permet par ailleurs de limiter les dégradations de la couche métallique dues à une potentielle remise à l'air. Dans cette optique, on prévoit avantageusement que la première couche d'encapsulation soit déposée de façon conforme sur la couche métallique.

La couche métallique est également dopée, par exemple avec la même espèce dopante que la première couche d'encapsulation. Le dopage de la couche métallique permet d'en modifier la stœchiométrie et la structure atomique ainsi que d'ajouter de nouveaux éléments chimiques en son sein. Par ailleurs, le dopage de la couche métallique permet d'obtenir une très bonne tenue en température de l'élément chauffant, ce qui permet d'améliorer les performances du dispositif mémoire.

Par ailleurs, en améliorant la tenue en température par le biais du dopage, on accroît le nombre de matériaux pouvant être employés pour former l'élément chauffant. Des matériaux qui auparavant n'étaient pas de bons candidats pour la réalisation de l'élément chauffant du fait de leur mauvaise tenue en température, mais qui présentaient d'autres propriétés physiques avantageuses, peuvent être employés. En effet, l'implantation permet de rattraper cette mauvaise tenue en température naturelle et ainsi de conférer à l'élément chauffant une tenue en température satisfaisante voire supérieure à ce qui aurait été obtenu par l'emploi de matériaux présentant naturellement une tenue en température correcte mais n'ayant pas été dopés.

Par ailleurs, le dopage de la couche métallique permet de conférer à cette dernière une meilleure résistivité, ce qui est très avantageux pour permettre un fort effet Joule au niveau de l'élément chauffant et donc un meilleur contrôle de l'état de la couche mémoire.

Un deuxième aspect de l'invention concerne un procédé de fabrication d'un dispositif mémoire à changement de phase comprenant un point mémoire, le procédé comprenant les étapes suivantes :
a. fournir un ensemble comprenant au moins :
   i. une couche métallique à base d'un matériau métallique et destinée à former un élément chauffant pour le point mémoire, la couche métallique présentant un premier flanc principal,
   ii. une première couche d'encapsulation s'étendant depuis le premier flanc principal de la couche métallique,
b. implanter une espèce dite première espèce dopante dans une portion, dite dopée, de la première couche d'encapsulation, la portion dopée s'étendant depuis le flanc principal de la couche métallique,
c. former contre une face de la couche métallique un empilement comprenant :
   i. une couche dite couche mémoire à base d'un matériau à changement de phase, couplée thermiquement avec la couche métallique de sorte que de la chaleur produite par effet Joule par la couche métallique soit transférée à la couche mémoire,
   ii. une électrode supérieure.

Le procédé comprend également une étape de dopage de la couche métallique, par exemple avec la même espèce dopante que la première couche d'encapsulation. L'implantation de la couche métallique, et donc de l'élément chauffant, permet non seulement une modification de sa composition mais également son amorphisation. En effet, les méthodes généralement utilisées pour la formation de la couche métallique (notamment le dépôt chimique par flux alterné, qui permet d'obtenir des couches très fines) fonctionnent en saturant la structure par une face, couche après couche. On obtient ainsi des plans selon un empilement ordonné, ce qui constitue un chemin de conduction facile à emprunter pour le courant. En l'état, la résistivité de l'élément chauffant est donc faible. En conséquence, l'effet Joule n'est pas très important, ce qui est défavorable pour le fonctionnement du point mémoire. En réalisant l'implantation de l'élément chauffant, on désordonne cet empilement, ce qui permet d'augmenter la résistivité de l'élément chauffant, donc d'augmenter l'effet Joule, et enfin d'améliorer le contrôle de la programmation et d'augmenter les performances du point mémoire

De préférence, l'étape d'implantation de la couche métallique est réalisée au travers de la première couche d'encapsulation. Réaliser l'implantation au travers de la première couche d'encapsulation permet de transférer des espèces depuis la première couche d'encapsulation jusque dans la couche métallique. Ce transfert est particulièrement favorable lorsque les espèces transférées peuvent contribuer à une augmentation de la résistivité et de la tenue en température de la couche métallique, ce qui est notamment le cas lorsque la première couche d'encapsulation comprend du silicium et/ou de l'azote. L'implantation permet ainsi une augmentation de la résistivité et une augmentation de la tenue en température de la couche métallique non seulement grâce à l'implantation de l'espèce dopante mais également à l'implantation d'une ou plusieurs espèces provenant de la première couche d'encapsulation.

Il est à noter que l'implantation de la première couche d'encapsulation (et éventuellement de la couche mémoire) est compatible avec toutes les architectures PCM intégrant un élément chauffant sous-jacent à la couche mémoire. Par ailleurs, le surcoût de cette étape est faible, pour un gain en performance du dispositif mémoire élevé.

Les avantages procurés par le dispositif mémoire selon l'invention s'appliquent mutatis mutandis au procédé selon l'invention, et inversement.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe transversale illustrant selon un exemple l'emplacement d'un dispositif PCM entre les niveaux métalliques en fin de ligne de fabrication (communément désigné en anglais par « back-end of line », ou simplement « back-end »).
La figure 2 représente un schéma en perspective d'un point mémoire selon un exemple de réalisation.
Les figures 3A à 23B illustrent un mode de réalisation du procédé selon l'invention.
La figure 24 représente le résultat d'une simulation de l'implantation carbone d'une tri-couche SiN/TiN/SiN.
Les figures 25A à 25D sont des vues en coupe de modes de réalisation du dispositif selon l'invention dans lesquels le point mémoire présente différentes structures.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions et dimensions relatives des couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la première couche d'encapsulation est à base d'au moins un parmi les matériaux suivants : SiN, SiCN, SiC.

Selon un exemple, la concentration en première espèce dopante dans la portion dopée de la première couche d'encapsulation est supérieure ou égale à 5.10²⁰ atomes/cm³, de préférence supérieure ou égale à 1.10²¹ atomes/cm³. Typiquement, la concentration en première espèce dopante dans la portion dopée de la première couche d'encapsulation est inférieure ou égale à 1.10²² atomes/cm³.

Selon un exemple, la première couche d'encapsulation présente une épaisseur e₄₀₀ prise selon une direction perpendiculaire au premier flanc principal de la couche métallique, la portion dopée s'étendant sur une épaisseur e₄₅₀ selon cette même direction au sein de la première couche d'encapsulation, avec e₄₅₀ ≥ 0,05*e₄₀₀, de préférence e₄₅₀ ≥ 0,10*e₄₀₀.

Selon un exemple, la première couche d'encapsulation présente une épaisseur e₄₀₀ prise selon une direction perpendiculaire au premier flanc principal de la couche métallique, la portion dopée s'étendant sur une épaisseur e₄₅₀ selon cette même direction au sein de la première couche d'encapsulation, avec e₄₅₀ ≤ 0,5*e₄₀₀, de préférence e₄₅₀ ≤ 0,3*e₄₀₀. Le reste de la première couche d'encapsulation (pouvant être désigné portion non dopée) est lui de préférence moins dopé que la portion dopée. La portion dite non dopée est de préférence dopée à raison d'une concentration strictement inférieure à 5.10²⁰ atomes/cm³. On garantit ainsi qu'une portion significative de la couche d'encapsulation est moins dopée que la portion dopée. De cette façon, la portion dopée de la couche d'encapsulation assure le confinement thermique de la couche métallique tandis que la portion non dopée assure la protection de la couche métallique. L'épaisseur e₄₅₀ de la portion dopée dans la couche d'encapsulation peut être contrôlée par des moyens connus de l'homme du métier lors de l'implantation de la couche d'encapsulation (modulation de l'énergie d'implantation, de l'angle d'implantation...).

Selon un exemple, la couche métallique présente une épaisseur e₃₀₀ entre son premier flanc principal et son deuxième flanc principal, avec e₃₀₀ ≤ 10 nm. Cela permet de maximiser l'effet Joule ayant lieu dans la couche métallique et ainsi d'améliorer le contrôle de l'état de la couche mémoire.

Selon un mode de réalisation préféré, la couche métallique présente une portion dite portion principale s'étendant depuis le flanc de la couche diélectrique et une portion dite retour s'étendant transversalement depuis la portion principale. La portion principale et le retour de la couche métallique s'étendent de préférence principalement dans des directions sensiblement perpendiculaires. Typiquement, le retour de la couche métallique s'étend depuis une face supérieure d'un via métallique sous-jacent. Typiquement, la couche métallique présente une forme sensiblement invariante selon une direction perpendiculaire à la direction d'empilement. La couche métallique présente typiquement une forme de « L » en projection dans un plan parallèle à la direction d'empilement.

Selon un exemple préféré, la première couche d'encapsulation s'étend au-dessus du retour de la couche métallique. De préférence, la première couche d'encapsulation s'étend uniquement au-dessus du retour de la couche métallique. Ainsi, selon une direction perpendiculaire au flanc principal de la couche métallique, la première couche d'encapsulation ne s'étend pas au-delà du retour de la couche métallique. La première couche d'encapsulation peut par exemple s'étendre autant que le retour de la couche métallique selon cette même direction. La première couche d'encapsulation se trouve ainsi de préférence dans le creux défini par le « L » formé par la couche métallique.

Selon un exemple typique, la première couche d'encapsulation présente une épaisseur variable selon la direction d'empilement. Typiquement, l'épaisseur de la première couche d'encapsulation diminue en s'éloignant du retour de la couche métallique. Ainsi, la première couche d'encapsulation présente une base plus large que son sommet, sa base se situant typiquement au contact du retour de la couche métallique.

Selon l'invention, la couche métallique présente un dopage à base d'une deuxième espèce dopante, de préférence identique à la première espèce dopante. Il est également envisageable que la couche métallique présente un dopage à base d'une deuxième espèce dopante distincte de la première espèce dopante, et un dopage à base de la première espèce dopante. Que la deuxième espèce dopante soit identique ou non à la première espèce dopante, la concentration en deuxième espèce dopante au sein de la couche métallique est de préférence comprise entre 0% et 8%.

Selon un exemple préféré, le premier flanc principal de la couche métallique est intégralement dopé. Autrement dit, le premier flanc principal de la couche métallique est de préférence dopé sur toute sa hauteur. De préférence, le premier flanc principal de la couche métallique est uniformément dopé.

Selon un mode de réalisation préféré, le dispositif comprend en outre une première couche diélectrique s'étendant depuis le deuxième flanc principal de la couche métallique, la première couche diélectrique présentant une portion, dite dopée, présentant un dopage à base d'au moins une espèce, dite troisième espèce dopante, de préférence identique à la première espèce dopante, la portion dopée de la première couche diélectrique s'étendant depuis le deuxième flanc principal de la couche métallique. Les avantages obtenus par dopage de la première couche d'encapsulation sont également obtenus par dopage de la première couche diélectrique (confinement thermique de la couche métallique notamment).

Selon un exemple, la concentration en troisième espèce dopante dans la portion dopée de la première couche diélectrique est supérieure ou égale à 5.10²⁰ atomes/cm³, de préférence supérieure ou égale à 1.10²¹ atomes/cm³. Typiquement, la concentration en troisième espèce dopante dans la portion dopée de la première couche diélectrique est inférieure ou égale à 1.10²² atomes/cm³.

De préférence, la troisième espèce dopante est identique à la deuxième espèce dopante. Il est également envisageable que la portion dopée de la première couche diélectrique présente un dopage à base d'une troisième espèce dopante distincte de la deuxième espèce dopante, et un dopage à base de la deuxième espèce dopante, voire également un dopage à base de la première espèce dopage.

Selon un exemple, la première couche d'encapsulation présente un premier flanc principal et un deuxième flanc principal opposés l'un à l'autre, le deuxième flanc principal étant en regard du premier flanc principal de la couche métallique, le dispositif comprenant en outre une deuxième couche d'encapsulation contre le premier flanc principal de la première couche d'encapsulation. La deuxième couche d'encapsulation présente avantageusement un dopage, de préférence à base de la première espèce dopante.

Selon un exemple, la première espèce dopante est choisie parmi les espèces suivantes : le silicium, le carbone, l'argon, l'azote, l'oxygène, le xénon, le titane, le tantale, le tungstène, le cobalt, le germanium, le néon et leurs alliages. Les proportions atomiques de ces alliages ne sont pas obligatoirement fixées à 1:1. Comme cela sera décrit plus avant, des espèces dopantes distinctes peuvent être implantées lors de différente sous-étape d'implantation, que cela soit pour implanter une ou des même(s) couche(s) que pour implanter des couches distinctes. L'argon, le xénon, l'azote, l'oxygène, le carbone, le silicium et le germanium sont tout particulièrement avantageux pour diminuer le coefficient de diffusion thermique de la première couche d'encapsulation (et, le cas échéant, de la deuxième couche d'encapsulation).

De préférence, la deuxième espèce implantée est identique à la première espèce implantée. De façon générale, la deuxième espèce implantée peut être choisie parmi les mêmes espèces dopantes que la première espèce implantée. Toutes ces espèces ont pour effet, lorsqu'elles sont implantées dans la couche métallique, d'en améliorer la tenue en température.

L'argon, le xénon, l'azote, l'oxygène, le carbone, le silicium et le germanium sont par ailleurs tout particulièrement avantageux pour augmenter la résistivité électrique de la couche métallique et ainsi augmenter l'effet Joule. L'argon et le xénon agissent notamment sur la résistivité de la couche métallique en modifiant sa structure. Leur implantation dans la couche métallique provoque une amorphisation qui provoque l'augmentation de la résistivité. L'azote, l'oxygène, le carbone, le silicium et le germanium modifient quant à eux la composition du matériau constituant la couche métallique, ce qui provoque l'augmentation de la résistivité.

De préférence, la troisième espèce implantée est identique à la première espèce implantée. De façon générale, la troisième espèce implantée peut être choisie parmi les mêmes espèces dopantes que la première espèce implantée.

Selon un exemple, selon une direction perpendiculaire au premier flanc principal de la couche métallique, la couche mémoire présente une longueur L_{cm} et l'élément chauffant présente une épaisseur e_{ec}, avec L_{cm} > γ * e_{ec}, avec γ > 2, de préférence γ > 5, de préférence γ > 10.

Selon un exemple, le matériau métallique est à base d'au moins un parmi les matériaux suivants : TiN, TiC, TiSiN, TiSiCN, TiWN, TaN, TaCN. Les proportions atomiques de ces alliages ne sont pas obligatoirement fixées à 1:1.

Selon un exemple, la couche métallique présente une face inférieure et le dispositif comprend en outre un via métallique en contact avec la face inférieure de la couche métallique.

Selon un mode de réalisation avantageux du procédé selon l'invention, ce dernier comprend en outre une étape d'implantation d'une espèce dite deuxième espèce dopante, de préférence identique à la première espèce dopante, dans la couche métallique, l'étape d'implantation de la couche métallique se faisant au travers de la première couche d'encapsulation.

Comme il sera vu plus avant, la première couche d'encapsulation peut également servir de couche de protection lors de la gravure d'une portion de la couche métallique. Dans cette optique, on prévoit avantageusement que la première couche d'encapsulation soit déposée de façon conforme sur la couche métallique.

Selon un exemple, la première couche d'encapsulation présente un premier flanc principal et un deuxième flanc principal opposés l'un à l'autre, le deuxième flanc principal étant en regard du premier flanc principal de la couche métallique, et le procédé comprend en outre la formation d'une deuxième couche d'encapsulation contre le premier flanc principal de la première couche d'encapsulation.

Selon un exemple, la deuxième couche d'encapsulation est à base d'au moins un parmi les matériaux suivants : SiN, SiCN, SiC.

Selon un exemple, l'implantation de la deuxième espèce dopante dans la couche métallique est réalisée au travers de la deuxième couche d'encapsulation. Réaliser l'implantation de la couche métallique au travers de la deuxième couche d'encapsulation présente les mêmes avantages que de la réaliser au travers de la première couche d'encapsulation, avec cette fois deux couches depuis lesquelles des espèces peuvent être transférées dans la couche métallique et augmenter sa résistivité. Ainsi, on peut prévoir que l'implantation soit effectuée de sorte à transférer jusque dans l'élément chauffant une espèce dopante issue de la première couche d'encapsulation et une espèce dopante différente, cette fois issue de la deuxième couche encapsulation. Les propriétés de l'élément chauffant peuvent être améliorées par l'implantation de ces deux espèces distinctes. Pour favoriser le transfert d'espèces dopantes depuis la deuxième couche d'encapsulation vers la couche métallique, on peut prévoir que l'épaisseur e₄₀₀ de la première couche d'encapsulation soit faible, par exemple inférieure ou égale à 1 nm.

Selon un exemple, le premier flanc principal de la couche métallique n'est pas recouvert lors de l'étape d'implantation de la deuxième espèce dopante. L'étape de fourniture de l'ensemble en début de procédé peut ainsi comprendre les étapes suivantes :
a. Fournir la couche métallique,
b. Implanter la couche métallique avec la deuxième espèce dopante,
c. Former la première couche d'encapsulation.

Selon un exemple, la fourniture de l'ensemble comprend les étapes suivantes :
a. fournir une couche support présentant une face supérieure s'étendant principalement dans un plan parallèle au plan longitudinal,
b. former sur une portion de la face supérieure de la couche support une couche diélectrique, la couche diélectrique présentant un flanc s'étendant de préférence principalement dans un plan parallèle au plan transversal,
c. former au moins contre le flanc de la couche diélectrique, et de préférence sur la face supérieure de la couche support, la couche métallique.

L'utilisation d'une couche support pour former la couche métallique permet de former celle-ci avec plus de précision. Cela permet également de donner à la couche métallique la forme souhaitée sans avoir recours à des étapes de gravure qui pourraient l'endommager.

Selon un exemple, la couche diélectrique comprend une première couche diélectrique et une deuxième couche diélectrique, la deuxième couche diélectrique et la couche support étant séparées par la première couche diélectrique, et le procédé comprend en outre une étape de polissage d'une portion supérieure de la couche métallique et de la deuxième couche diélectrique, avec un arrêt sélectif sur la première couche diélectrique. L'étape de polissage peut notamment avoir lieu avant l'étape de formation de la couche mémoire, et de préférence après l'étape d'implantation.

Afin de permettre un polissage sélectif de la deuxième couche diélectrique sélectivement à la première couche diélectrique, ces deux couches diélectriques sont de natures différentes. Par exemple, la première couche diélectrique peut être à base de SiN et la deuxième couche diélectrique à base de SiO₂.

Avoir recours à une couche support comprenant deux couches de natures différentes et réaliser un polissage de la couche métallique s'arrêtant lorsque la deuxième couche diélectrique est entièrement épuisée permet de très bien contrôler la hauteur de la couche métallique. L'arrêt de polissage se fait sans endommager la portion de la couche métallique restante.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau **M, un** substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

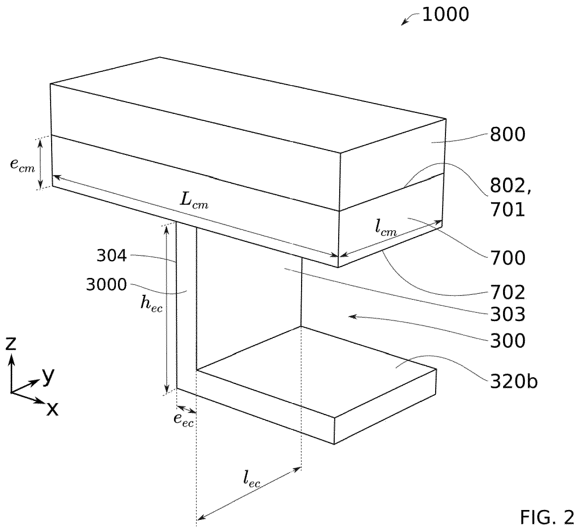

Un repère, de préférence orthonormé, comprenant les axes X, Y, Z est représenté en figures 2 à 23B et 25A à 25D. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan longitudinal XY. L'épaisseur est prise selon une direction normale au plan d'extension principal de la couche. Ainsi, une couche ou portion de couche présente typiquement une épaisseur selon Z, lorsqu'elle s'étend principalement le long du plan longitudinal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient, sauf mention contraire, « à 10% près, de préférence à 5% près ».

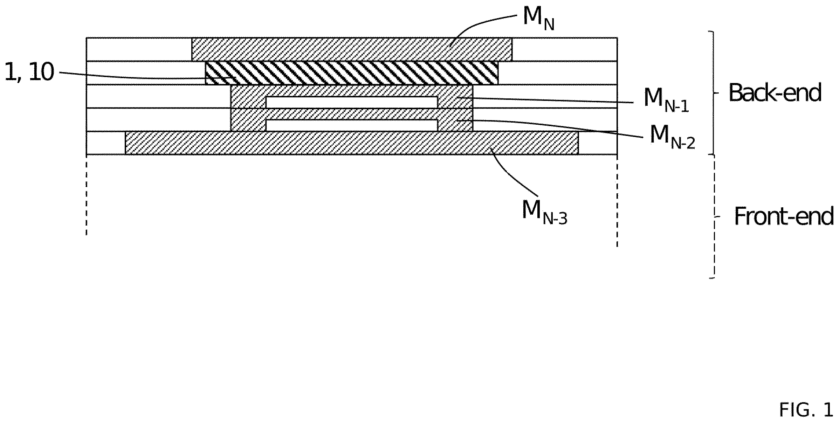

Un dispositif PCM 1 est typiquement fabriqué en fin de ligne de fabrication (communément désigné par back-end of line anglais, ou encore back-end). Le dispositif PCM 1 et son substrat peuvent être disposés entre deux niveaux métalliques M du back-end, notamment entre les deux derniers niveaux, par exemple entre M_{N} et M_{N-1} comme illustré sur la figure 1. La position de la partie du dispositif fabriquée en début de ligne de fabrication (habituellement qualifiée de front-end) est indiquée par des pointillée en figure 1. Les intégrations peuvent plus généralement aller jusqu'à dix niveaux métalliques ou plus. Le terme de substrat ne signifie pas nécessairement une monocouche et peut comprendre un empilement de couches notamment dans le cadre d'une réalisation en back-end.

### Procédé de fabrication d'un dispositif mémoire à changement de phase

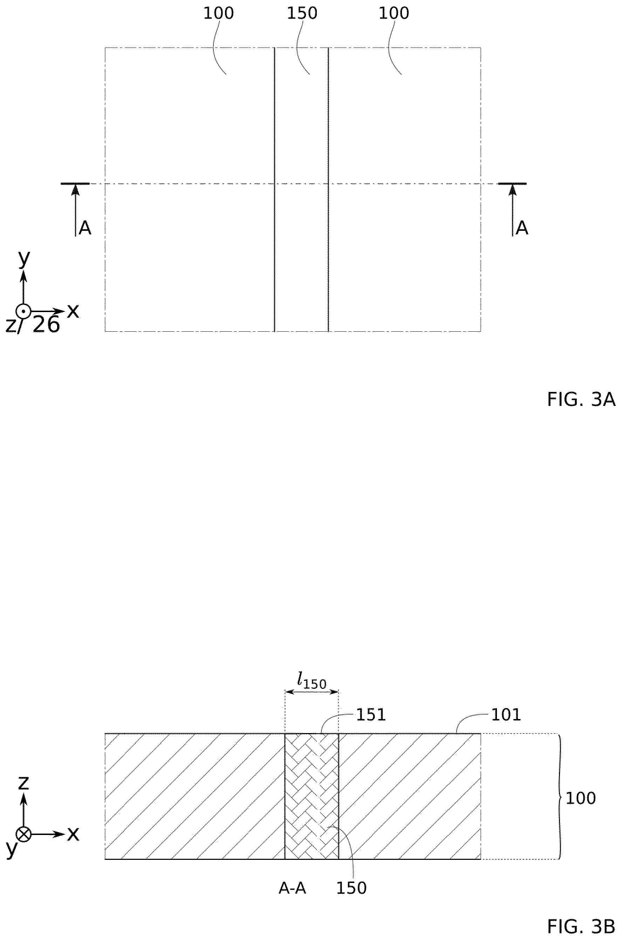

Un mode de réalisation du procédé selon l'invention va maintenant être décrit en référence aux figures 3A à 23B. Pour des raisons de clarté, ces figures illustrent l'obtention d'un unique point mémoire. Naturellement, ces étapes peuvent permettre d'obtenir simultanément de nombreux points mémoires.

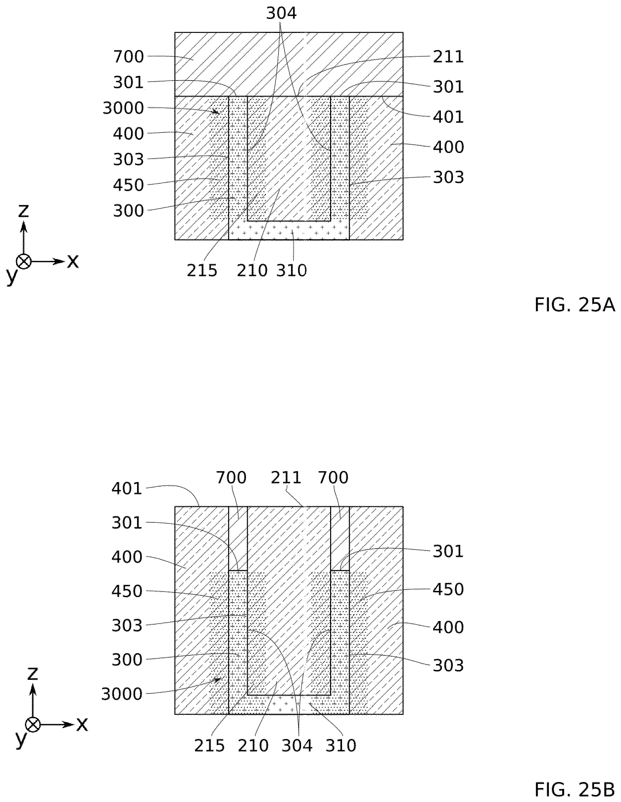

Par ailleurs, ces figures illustrent la fabrication d'un point mémoire dont la structure peut être qualifiée de structure « WALL », de l'anglais « mur ». Dans cette structure, l'élément chauffant, la couche mémoire et l'électrode supérieure sont empilés, dans cet ordre, selon la direction d'empilement Z. L'élément chauffant présente par ailleurs dans le cas de cette structure une forme invariante selon une direction perpendiculaire (ici Y) à la direction d'empilement Z (par exemple la forme d'un pavé droit ou, vu en coupe, la forme d'un « L »). Les étapes décrites ci-dessous peuvent cependant parfaitement être adaptées à la formation de points mémoires présentant d'autres structures. Différents exemples de structures seront présentés plus avant, en référence aux figures 25A à 25D.

Il est à noter que toutes les figures indexées « A » correspondent à des vues de dessus selon la direction d'empilement Z, tandis que toutes les figures indexées « B » correspondent à des vues de côté.

Les figures 3A et 3B illustrent la fourniture d'une couche support 100. La couche support 100 présente une face supérieure 101 s'étendant principalement dans un plan longitudinal XY.

La couche support 100 peut correspondre à un niveau métallique du back-end, typiquement le niveau M_{N-1}, ou bien à une partie de ce niveau. Elle peut être désignée ligne métallique inférieure ou encore de ligne d'interconnexion inférieure. Elle comprend typiquement au moins un via métallique 150 dont la face supérieure 151 affleure de préférence la face supérieure 101 de la couche support 100. Le via métallique 150 peut par exemple être à base de tungstène. Il présente une largeur l₁₅₀ selon la première direction X, avec de préférence l₁₅₀ ≥ 1 nm, et de préférence l₁₅₀ ≤ 500 nm.

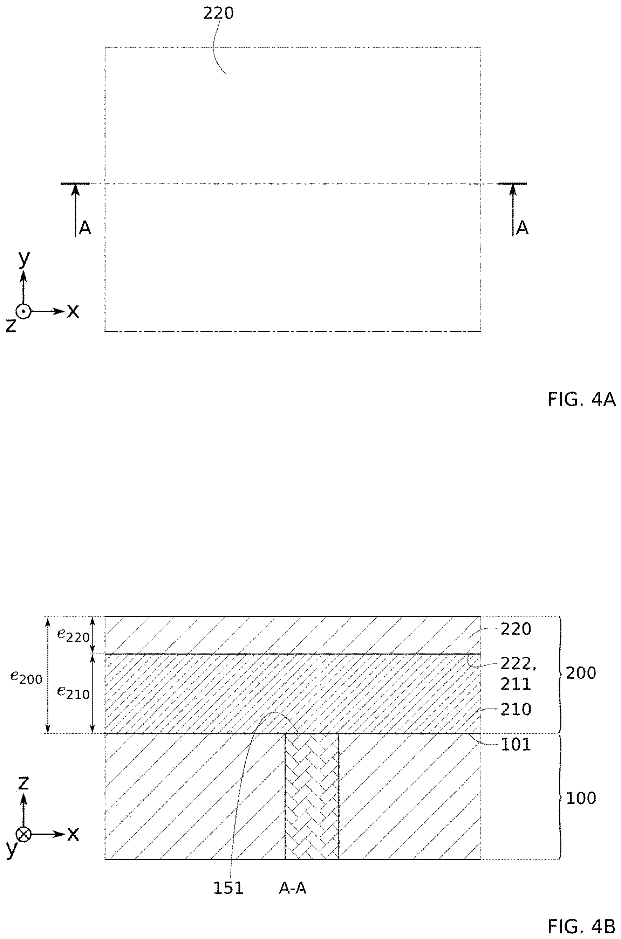

Les figures 4A et 4B illustrent la formation d'une couche diélectrique 200 sur la face supérieure 101 de la couche support 100. La couche diélectrique 200 comprend typiquement une première couche diélectrique 210 et une deuxième couche diélectrique 220, la première couche diélectrique 210 s'étendant depuis la face supérieure 101 de la couche support 100 et la deuxième couche diélectrique 220 s'étendant sur la première couche diélectrique 210. De préférence, la première couche diélectrique 210 et la deuxième couche diélectrique 220 sont au contact l'une de l'autre. Dans ce cas de figure, la face supérieure 211 de la première couche diélectrique 210 est au contact de la face inférieure 222 de la deuxième couche diélectrique 220.

La couche diélectrique 200, la première couche diélectrique 210 et la deuxième couche diélectrique 220 présentent respectivement une épaisseur e₂₀₀, e₂₁₀ et e₂₂₀ selon la direction d'empilement Z. Comme cela ressortira plus avant, l'épaisseur e₂₁₀ de la première couche diélectrique 210 peut déterminer la hauteur h_{ec} de l'élément chauffant du dispositif 1 obtenu en fin de procédé. Ainsi, on prévoit que e₂₁₀ soit sensiblement égale à la hauteur h_{ec} désirée pour l'élément chauffant.

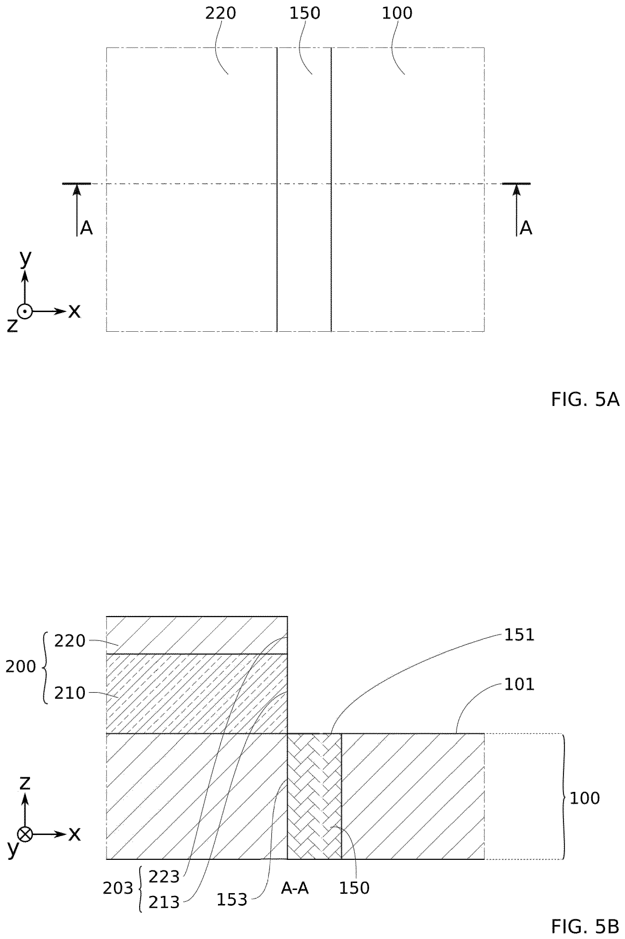

La couche diélectrique 200 peut par exemple être déposée sur toute la couche support 100 (figures 4A, 4B), puis être partiellement gravée afin de mettre à jour au moins partiellement, et de préférence entièrement, la face supérieure 151 du via métallique 150 (figures 5A, 5B).

De préférence, la gravure de la couche diélectrique 200 est configurée pour lui conférer un flanc 203 s'étendant sensiblement perpendiculairement, à 30% près, à la face supérieure 101 de la couche support 100. La première couche diélectrique 210 et la deuxième couche diélectrique 220 peuvent être gravées lors d'une même étape de gravure, ou bien lors de deux étapes de gravure successives. Dans les deux cas, préférentiellement, les flancs 213, 223 ainsi formés dans ces deux couches 210, 220 se trouvent dans le prolongement l'un de l'autre selon la direction d'empilement Z. Ils forment ensemble le flanc 203 de la couche diélectrique 200.

Le flanc 203 de la couche diélectrique 200 se trouve idéalement dans le prolongement d'un flanc 153, perpendiculaire à sa face supérieure 151, du via métallique 150. La couche diélectrique 200 peut également se trouver en partie au-dessus du via métallique 150, auquel cas son flanc 203 se trouve en avancée par rapport au flanc 153 du via métallique 150. Cette avancée n'excède de préférence pas 50 nm. Le flanc 203 de la couche diélectrique 200 peut également se trouver, en projection dans le plan longitudinal XY, en retrait par rapport au via métallique 150. Cela peut notamment être intéressant lorsque l'on souhaite que le via métallique 150 connecte un deuxième élément chauffant (les deux éléments chauffants pourront alors être sélectionnés séparément à l'aide des lignes métalliques se trouvant au-dessus des points mémoires correspondant). Le fait que le flanc 203 soit en retrait par rapport au via métallique 150 permet alors de laisser plus de place au-dessus du via métallique 150 pour la présence de ce deuxième élément chauffant.

Il est entendu que pour réaliser une pluralité de points mémoires 1000, on structurera la couche diélectrique 200 de manière à former une pluralité de flancs 203 contre chacun desquels, comme cela sera décrit par la suite, un élément chauffant 3000 sera formé. De préférence, chacun des flancs 203 se situera au-dessus d'un via métallique 150 distinct.

A ce stade de procédé, il est possible de réaliser une implantation d'une troisième espèce dopante dans la couche diélectrique 200 (implantation non représentée sur les figures). Notamment, on peut implanter une portion dite dopée 215 de la première couche diélectrique 210 s'étendant depuis le flanc 203 de cette dernière.

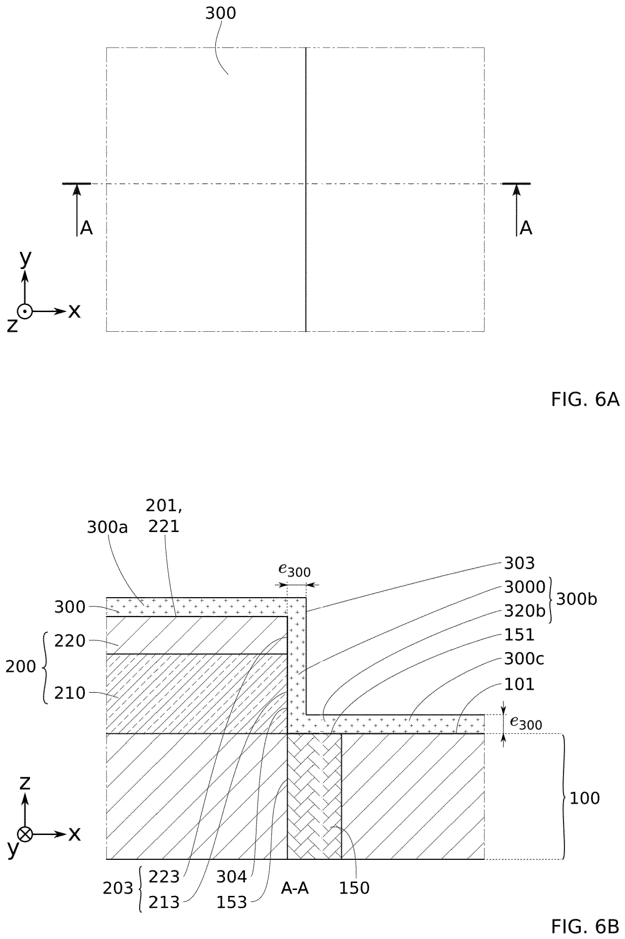

Les figures 6A et 6B illustrent ensuite la formation d'une couche métallique 300 sur la couche diélectrique 200 et sur la couche support 100. La couche métallique 300 peut être déposée, de préférence de façon conforme :
a. sur la face supérieure 201 de la couche diélectrique 200, et plus particulièrement sur la face supérieure 221 de la deuxième couche diélectrique 220,
b. contre le flanc 203 de la couche diélectrique 200, et donc à la fois contre le flanc 213 de la première couche diélectrique 210 et contre le flanc 223 de la deuxième couche diélectrique 220,
c. sur la face supérieure 101 de la couche support 100 et notamment sur la face supérieure 151 du via métallique 150.

Ainsi, la couche métallique 300 épouse la forme de la couche diélectrique 200. Elle se trouve par ailleurs de préférence en contact avec la face supérieure 151 du via métallique 150.

On distingue ainsi trois portions de la couche métallique 300 :
a. une première portion 300a s'étendant au-dessus du plan dans lequel s'étend la face supérieure 201 de la couche diélectrique 200,
b. une deuxième portion 300b s'étendant au-dessus du via métallique 150 et éventuellement, si la couche diélectrique 200 se trouve en retrait par rapport au via métallique 150, au-dessus d'une partie de la couche support 100 n'étant pas le via métallique 150 et n'étant pas recouverte par la couche diélectrique 200,
c. une troisième portion 300c s'étendant au-dessus de la partie restante de la couche support 100 n'étant pas le via métallique et n'étant pas recouverte par la couche diélectrique 200.

L'élément chauffant 3000 du point mémoire sera essentiellement formé par la deuxième portion 300b et une partie de la portion 300c.

La première portion 300a et la troisième portion 300c présentent chacune des plans d'extension principaux parallèles au plan longitudinal XY et leur épaisseur est ainsi mesurée selon la direction d'empilement Z. La deuxième portion 300b présente une forme de « L », composé d'une portion dite portion principale s'étendant depuis le flanc 203 de la couche diélectrique 200 et d'une portion dite « retour » 320b s'étendant depuis la face supérieure 151 du via métallique 150. Le retour 320b de la deuxième portion 300b est séparé de la couche diélectrique 200 par la portion principale du L. La portion principale du « L » correspond à une paroi 3000 formée par la couche métallique 300 contre le flanc 203 de la couche diélectrique 200. Cette paroi 3000 s'étend notamment entre un premier flanc principal 303 et un deuxième flanc principal 304 de la couche métallique 300. La paroi 3000 est en contact avec la face supérieure 151 du via métallique 150. C'est notamment cette paroi 3000 qui aura la fonction d'élément chauffant au sein du point mémoire 1000.

L'épaisseur de la paroi 3000 est mesurée selon la première direction X. L'épaisseur du retour 320b de la deuxième portion 300b est mesurée selon la direction d'empilement Z.

La couche métallique 300 présente une épaisseur e₃₀₀ mesurée selon la première direction X ou la direction d'empilement Z en fonction de la portion considérée. Dans le cas typique d'un dépôt conforme, e₃₀₀ est identique dans les trois portions 300a, 300b, 300c de la couche métallique 300. e₃₀₀ est de préférence inférieure à 10 nm.

Afin d'obtenir une très bonne conformité de la couche métallique 300, cette étape peut être réalisée par un dépôt chimique tel qu'un dépôt chimique en phase vapeur (couramment abrégé CVD, de l'anglais « Chemical Vapor Deposition ») ou un dépôt par couches atomiques (couramment abrégé ALD, de l'anglais « Atomic Layer Deposition »). Il est cependant envisageable de recourir à d'autres méthodes de dépôt. On préférera les techniques de dépôt permettant de garantir une bonne conformité de l'épaisseur de la paroi 3000.

Il est à noter que la couche métallique 3000 peut ne pas être déposée sur toutes les régions citées précédemment, tant qu'elle forme à minima la paroi 3000. Il est envisageable que la couche métallique 300 soit déposée uniquement contre le flanc 203 de la couche diélectrique 200, et donc, dès cette étape de dépôt, ne former que la paroi 3000, ou bien uniquement contre le flanc 203 et sur la face supérieure 151 du via métallique 150 et donc, dès cette étape de dépôt, ne former que la deuxième portion 300b.

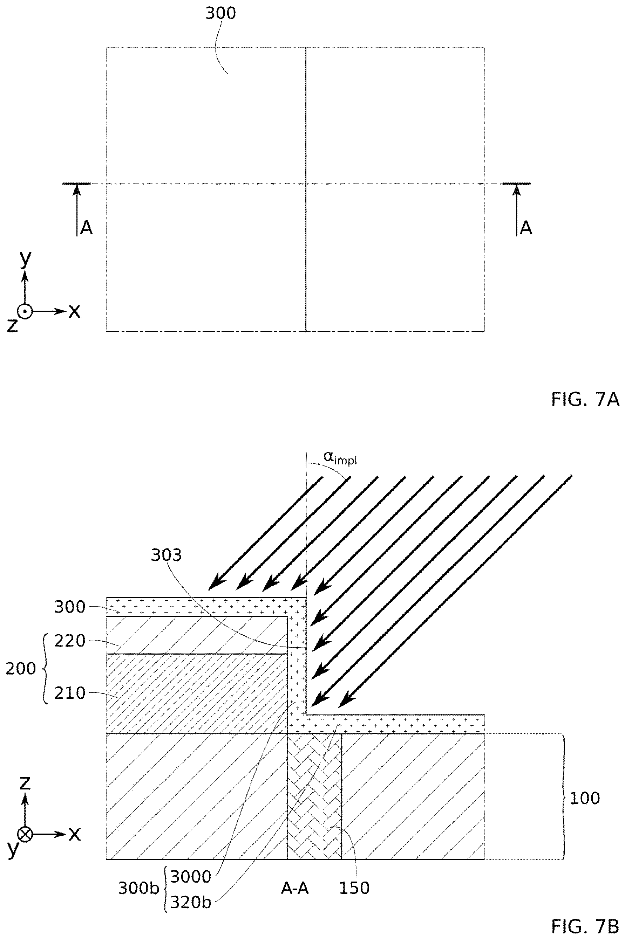

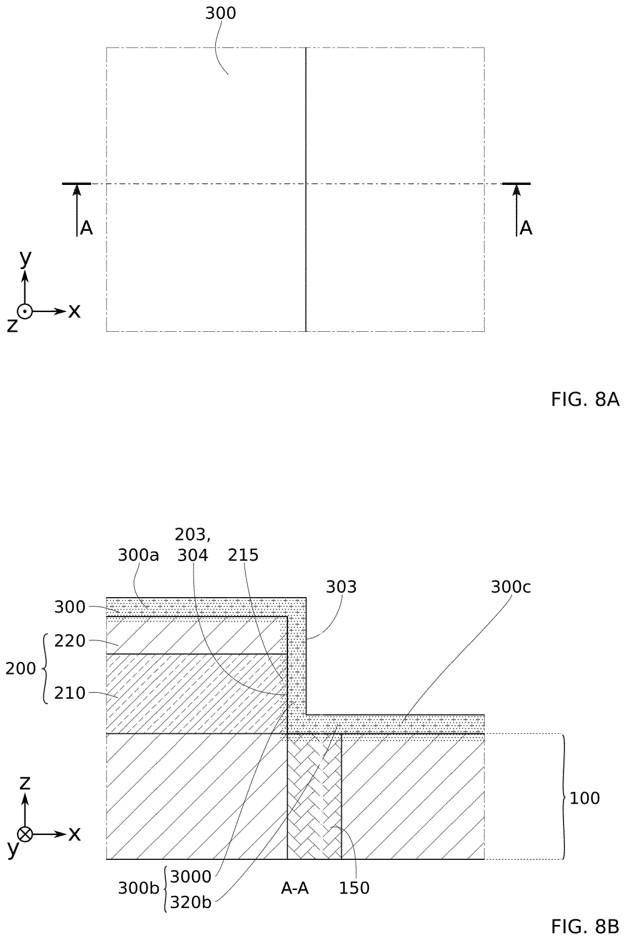

Comme illustré en figures 7A et 7B, il est possible à ce stade du procédé de réaliser une étape d'implantation d'une deuxième espèce dopante dans la couche métallique 300 à partir au moins de son premier flanc principal 303. Cette étape d'implantation sera décrite plus en détails plus avant. Avantageusement, l'implantation s'étend jusque dans la première couche diélectrique 210, et éventuellement jusque dans la deuxième couche diélectrique 220. La première couche diélectrique 210 présente ainsi une portion dopée 215 s'étendant depuis son flanc 203. Les figures 8A et 8B illustrent le dopage pouvant être obtenu dans la couche métallique après l'implantation réalisée lors de l'étape illustrée à la figure 7.

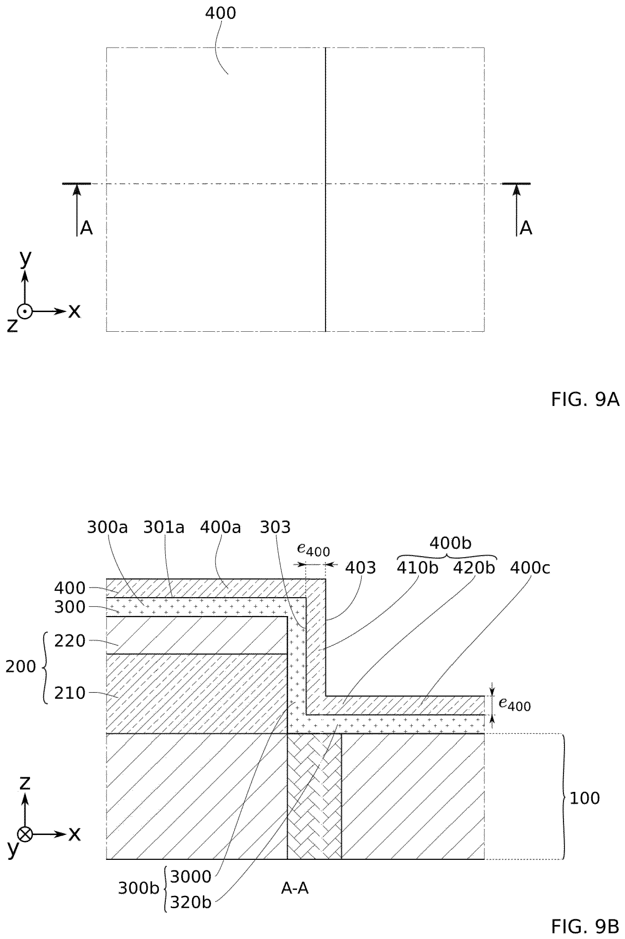

Les figures 9A et 9B illustrent la formation d'une première couche d'encapsulation 400 sur la couche métallique 300. Cette étape est de préférence réalisée moins de 24 heures après la formation de la couche métallique 300. Cela permet d'éviter une oxydation trop importante de la couche métallique 300.

La première couche d'encapsulation 400 est notamment déposée, de préférence de façon conforme :
a. sur une face supérieure 301a de la première portion 300a de la couche métallique 300,
b. contre le premier flanc principal 303 de la couche métallique 300,
c. sur une face supérieure 301c de la troisième portion 300c de la couche métallique 300.

Ainsi, la première couche d'encapsulation 400 épouse la forme de la couche métallique 300. Elle se trouve de préférence en contact direct avec elle.

On distingue ainsi trois portions de la première couche d'encapsulation 400 :
a. une première portion 400a s'étendant au-dessus du plan dans lequel s'étend la face supérieure 301a de la première portion 300a de la couche métallique 300,
b. une deuxième portion 400b s'étendant au-dessus, selon la direction d'empilement Z, du retour 320b de la deuxième portion 300b de la couche métallique 300, et, selon la première direction X, à côté du premier flanc principal 303 de la couche métallique 300,
c. une troisième portion 400c s'étendant au-dessus de la troisième portion 300c de la couche métallique 300.

La première couche d'encapsulation 400 présente une épaisseur e₄₀₀ mesurée selon la première direction X ou la direction d'empilement Z en fonction de la portion considérée. Dans le cas typique d'un dépôt conforme, e₄₀₀ est identique dans les trois portions 400a, 400b, 400c de la première couche d'encapsulation 400. e₄₀₀ est typiquement supérieure à 5 nm, et de préférence inférieure à 30 nm.

A nouveau, on préférera une technique de dépôt garantissant une bonne conformité de la première couche d'encapsulation 400 (CVD, ALD).

La deuxième portion 400b de la première couche d'encapsulation 400 présente une forme de marche. Cette marche comprend notamment une partie en forme de « L » constituée :
a. d'une portion principale 410b s'étendant entre un premier flanc principal 403 et un deuxième flanc principal 404 de la première couche d'encapsulation 400, le deuxième flanc principal 404 de la première couche d'encapsulation 400 se trouvant en regard du premier flanc principal 303 de la couche métallique 300,
b. d'un retour 420b se trouvant au-dessus, selon la direction d'empilement Z, du retour 320b défini par la deuxième portion 300b de la couche métallique 300, ce retour 420b étant séparé de la paroi 3000 par la portion principale 410b du « L ».

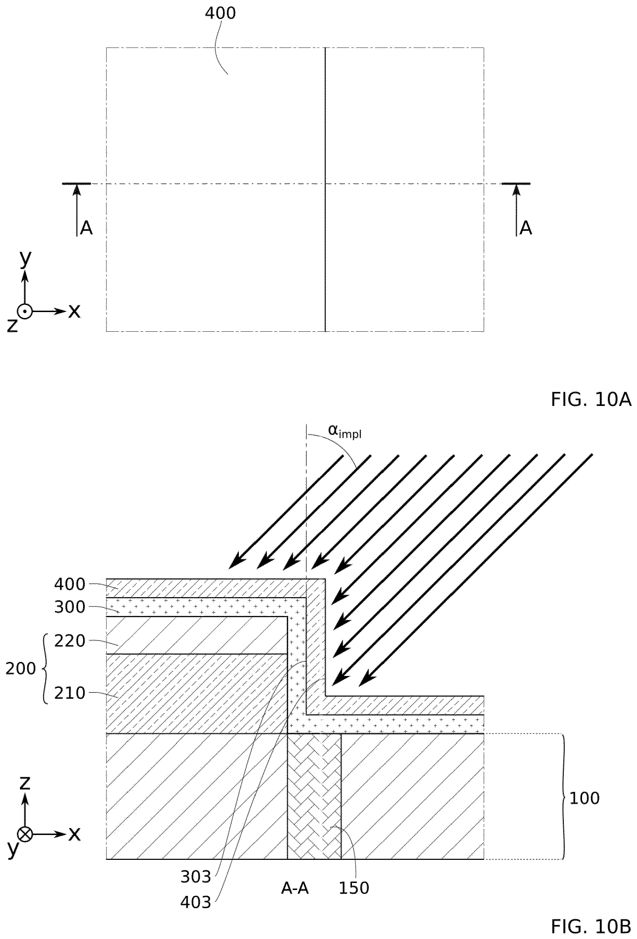

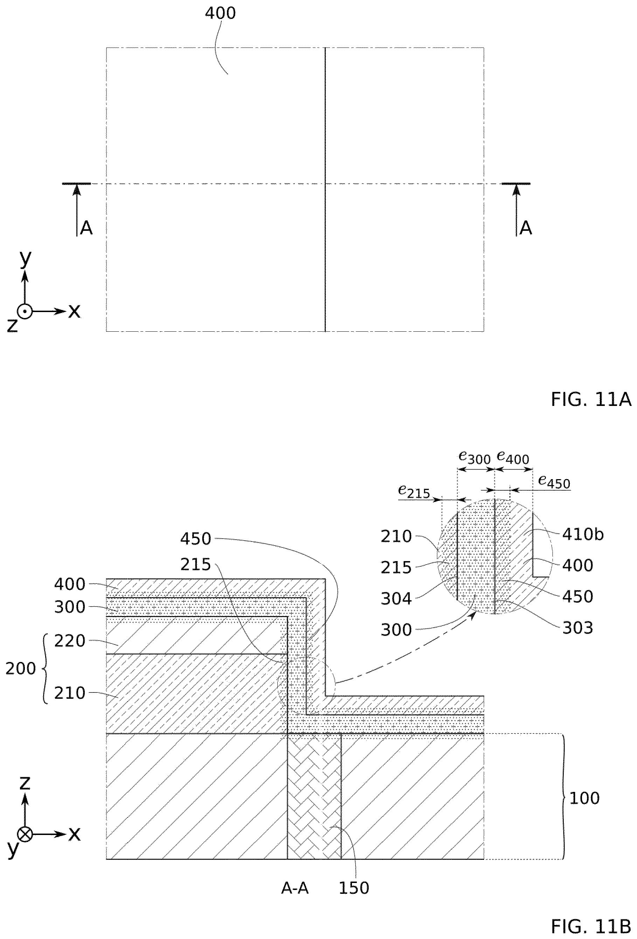

Comme illustré en figures 10A et 10B, il est possible à ce stade du procédé de réaliser une étape d'implantation d'une première espèce dopante dans au moins une portion de la portion principale 410b du « L » de la première couche d'encapsulation 400. Cette implantation est réalisée à ce stade du procédé à partir au moins du premier flanc principal 403 de la première couche d'encapsulation 400. De préférence, l'implantation de la première espèce s'étend jusque dans la couche métallique 300. Avantageusement, elle s'étend également jusque dans la couche diélectrique 200, et notamment dans une portion dopée 215 de la première couche diélectrique 210. Cette étape d'implantation sera décrite plus en détails plus avant. Les figures 11A et 11B illustrent le dopage pouvant être obtenu dans la couche métallique après l'implantation réalisée lors de l'étape illustrée à la figure 10.

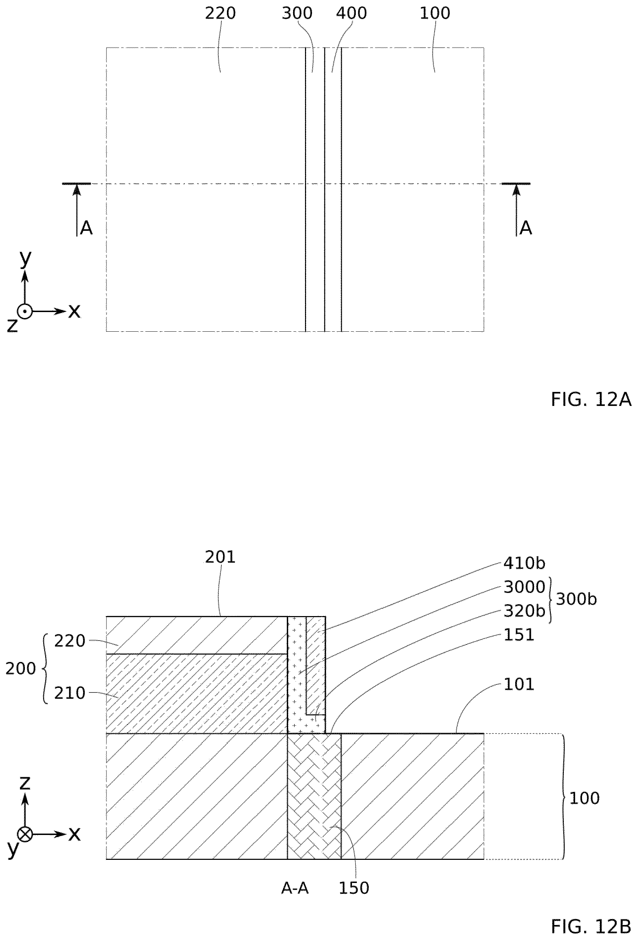

Les figures 12A et 12B illustrent ensuite une étape de retrait partiel, typiquement par gravure, de la première couche d'encapsulation 400 et de la couche métallique 300. Avantageusement, lors de cette étape, sont retirées :
a. la première portion 400a de la première couche d'encapsulation 400 et la première portion 300a de la couche métallique 300,
b. le retour 420b de la deuxième portion 400b de la première couche d'encapsulation 400 ainsi que la portion du retour 320b de la deuxième portion 320b sous-jacente selon la direction d'empilement Z. Ce retrait permet de rendre apparente une partie de la face supérieure 151 du via métallique 150.
c. la troisième portion 400c de la première couche d'encapsulation 400 et la troisième portion 300c de la couche métallique 300.

Ce retrait peut être réalisé à l'aide d'un procédé de gravure ionique réaction (couramment abrégé RIE, de l'anglais « Reactive-lon Etching »). On favorisera des conditions de gravure anisotropiques afin de graver préférentiellement les portions de couches dont le plan d'extension principal est parallèle au plan longitudinal XY tout en conservant la portion principale 410b de la première couche d'encapsulation 400.

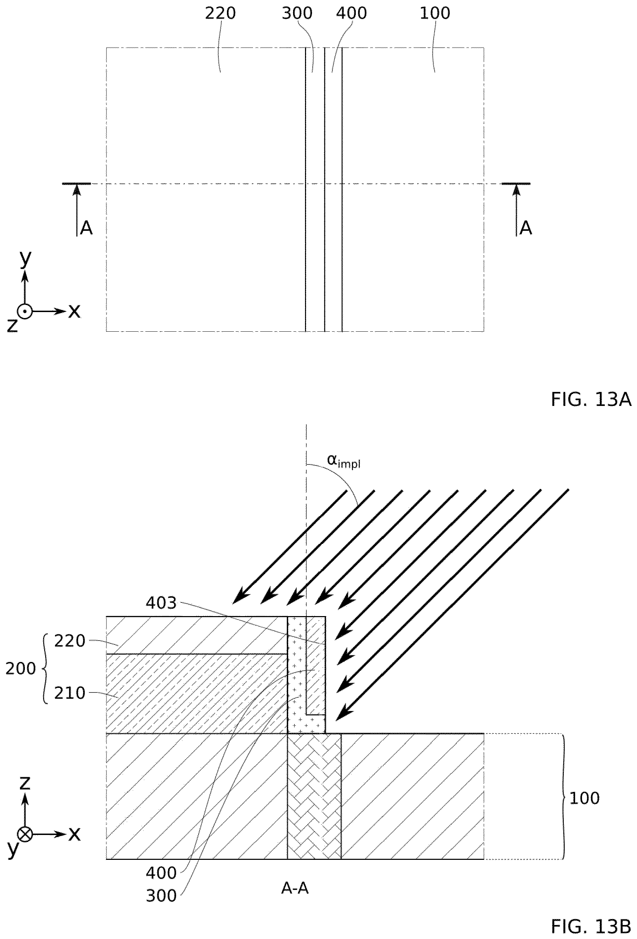

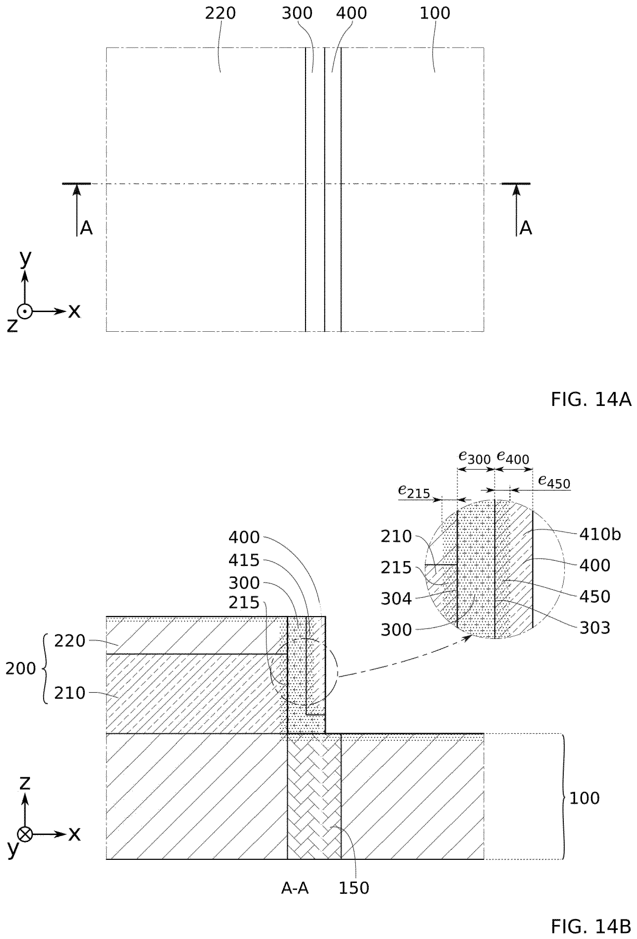

Comme illustré aux figures 13A et 13B, il est possible à ce stade du procédé de réaliser une étape d'implantation d'une espèce dopante dans la première couche d'encapsulation 400, de préférence également dans la couche métallique 300 et de préférence également dans la couche diélectrique 200. Cette étape d'implantation sera décrite plus avant. Les figures 14A et 14B illustrent le dopage pouvant être obtenu dans la couche métallique après l'implantation réalisée lors de l'étape illustrée à la figure 13. L'espèce dopante implantée lors de cette étape peut être la première espèce dopante, la deuxième espèce dopante, la troisième espèce dopante ou bien une espèce dopante distincte.

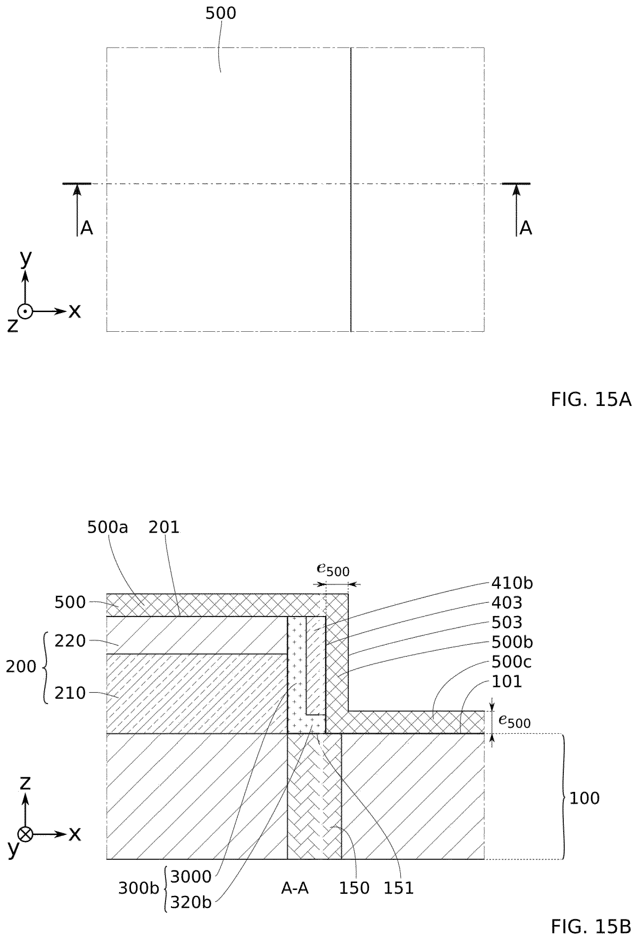

Les figures 15A et 15B illustrent la formation optionnelle d'une deuxième couche d'encapsulation 500 sur la couche métallique 300. La deuxième couche d'encapsulation 500 est notamment déposée, de préférence de façon conforme :
a. sur la face supérieure 201 de la couche support 200,
b. contre le premier flanc principal 403 de la première couche d'encapsulation 400,
c. sur la portion apparente de la face supérieure 151 du via métallique 150 et sur la face supérieure 101 de la couche support 100.

On distingue ainsi trois portions de la deuxième couche d'encapsulation 500 :
a. une première portion 500a s'étendant au-dessus, selon la direction d'empilement Z, du plan dans lequel s'étend principalement la face supérieure 201 de la couche diélectrique 200,
b. une deuxième portion 500b s'étendant notamment, selon la première direction X, à côté de la portion principale 410b de la première couche d'encapsulation 400 et à côté du retour 320b de la couche métallique 300. La deuxième portion 500b est de préférence en contact direct avec la portion principale 410b de la première couche d'encapsulation 400 et avec le retour 320b de la couche métallique 300. Cette deuxième portion 500b s'étend également de préférence depuis la portion de la face supérieure 151 du via métallique 150 rendue apparente lors de l'étape de retrait illustrée à la figure 12. Elle peut également être en contact avec une portion de la couche support 100 n'étant pas le via métallique 150, comme illustré en figure 15B.
c. une troisième portion 500c s'étendant au-dessus d'une portion de la couche support 100 n'étant pas recouverte par la couche support 200 et n'étant de préférence pas le via métallique.

La deuxième couche d'encapsulation 500 présente une épaisseur e₅₀₀ mesurée selon la première direction X ou la direction d'empilement Z en fonction de la portion considérée. Dans le cas typique d'un dépôt conforme, e₅₀₀ est identique dans les trois portions 500a, 500b, 500c de la deuxième couche d'encapsulation 500. e₅₀₀ est typiquement supérieure à 5 nm, et de préférence inférieure à 30 nm.

A nouveau, on préférera une technique de dépôt garantissant une bonne conformité de la première couche d'encapsulation 400 (CVD, ALD).

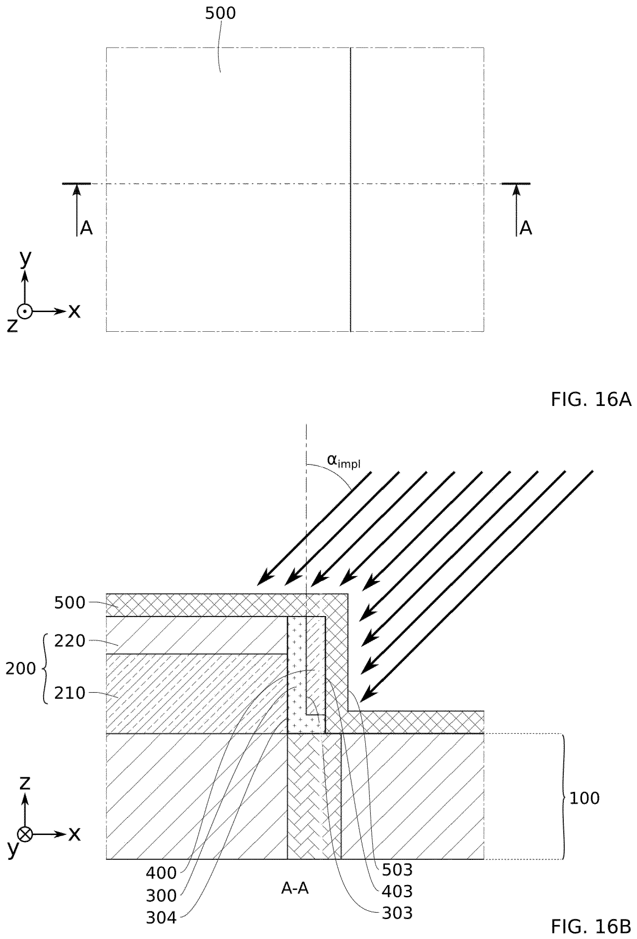

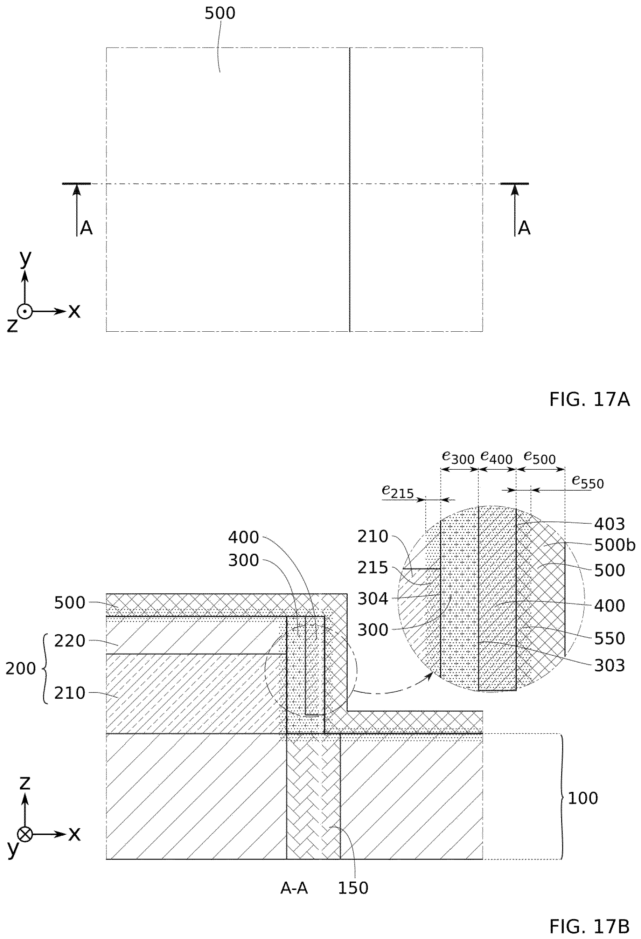

Comme illustré aux figures 16A et 16B, il est possible à ce stade du procédé de réaliser une étape d'implantation d'une espèce dopante dans la deuxième couche d'encapsulation 500. L'implantation s'étend de préférence également dans la première couche d'encapsulation 400, de préférence également dans la couche métallique 300 et de préférence également dans la couche diélectrique 200. Cette étape d'implantation sera décrite plus en détails plus avant. Les figures 17A et 17B illustrent le dopage pouvant être obtenu dans la couche métallique après l'implantation réalisée lors de l'étape illustrée à la figure 16. L'espèce dopante implantée lors de cette étape peut être la première espèce dopante, la deuxième espèce dopante, la troisième espèce dopante ou bien une espèce dopante distincte.

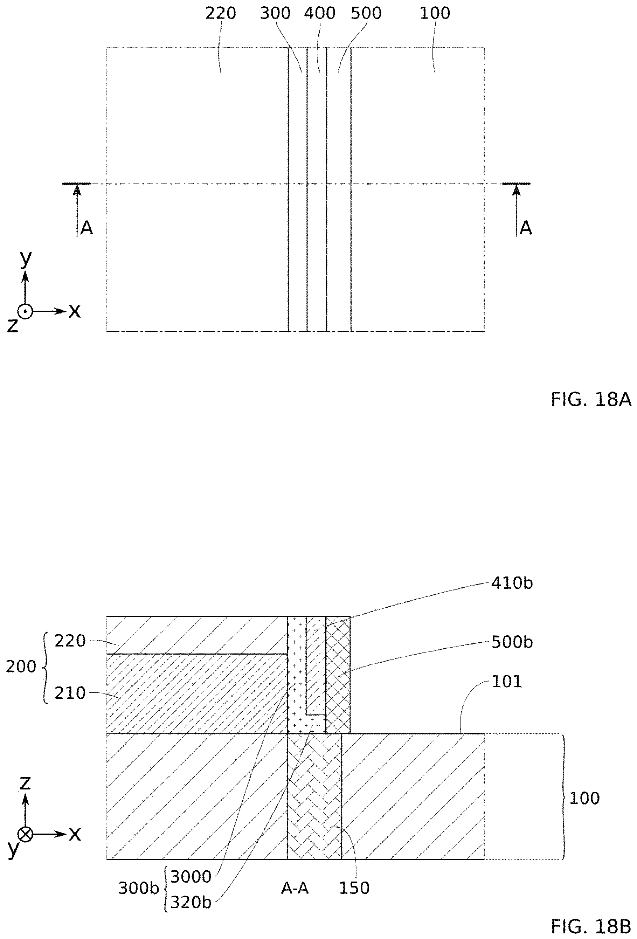

Les figures 18A et 18B illustrent le retrait partiel de la deuxième couche d'encapsulation 500.

Avantageusement, lors de cette étape, la première portion 500a et la troisième portion 500c de la deuxième couche d'encapsulation 500 sont retirées. Cette étape de retrait est optionnelle. Notamment, la première portion 500a pourra être retirée plus tard dans le procédé, comme cela sera décrit plus avant. La troisième portion 500c peut être conservée dans l'empilement, sans conséquence.

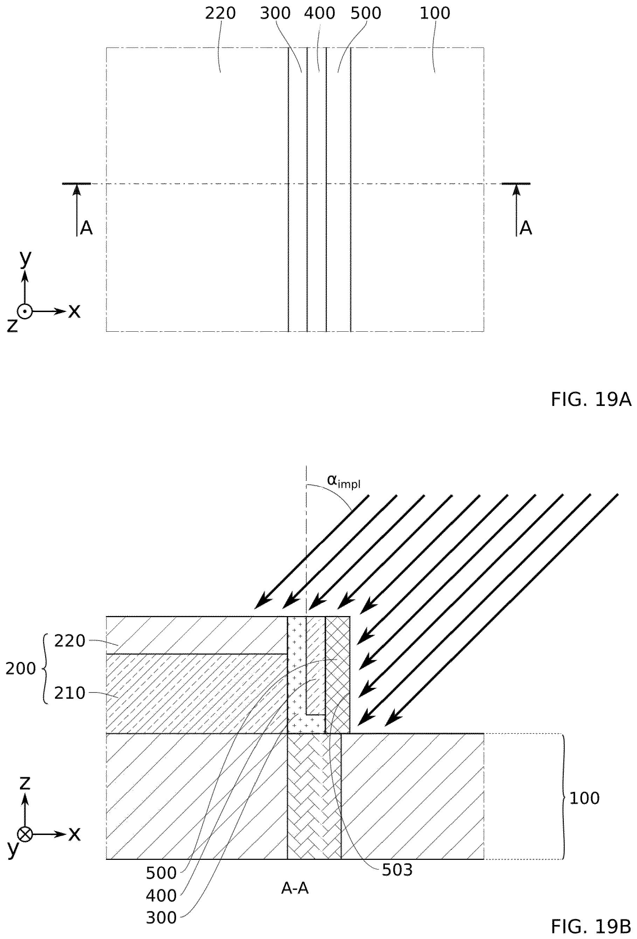

Comme illustré aux figures 19A et 19B, il est possible à ce stade du procédé de réaliser une étape d'implantation d'une espèce dopante dans la deuxième couche d'encapsulation 500. L'implantation s'étend de préférence également dans la première couche d'encapsulation 400, de préférence également dans la couche métallique 300 et de préférence également dans la couche diélectrique 200. Cette étape d'implantation sera décrite plus en détails plus avant. Les figures 19A et 19B illustrent le dopage pouvant être obtenu dans la couche métallique après l'implantation réalisée lors de l'étape illustrée à la figure 18.

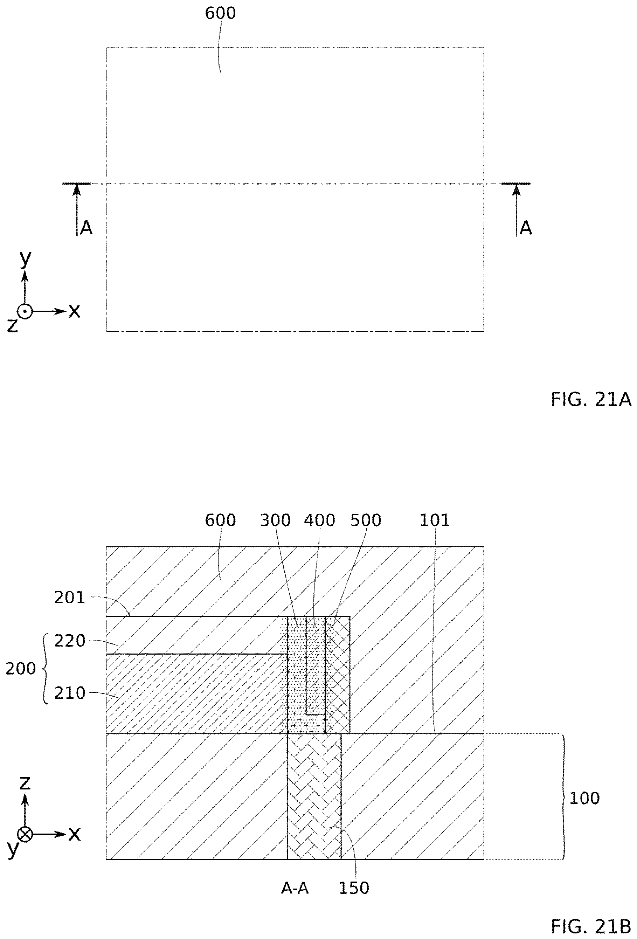

Les figures 21A et 21B illustrent une étape optionnelle de formation d'une couche de remplissage 600 au-dessus, selon la direction d'empilement Z, de la couche support 200, de la couche métallique 300, de la première couche d'encapsulation 400, de la deuxième couche d'encapsulation 500 et de la portion de la couche support 100 n'étant recouverte par aucune de ces couches 200, 300, 400, 500. La couche de remplissage 600 peut par exemple être à base de SiO₂.

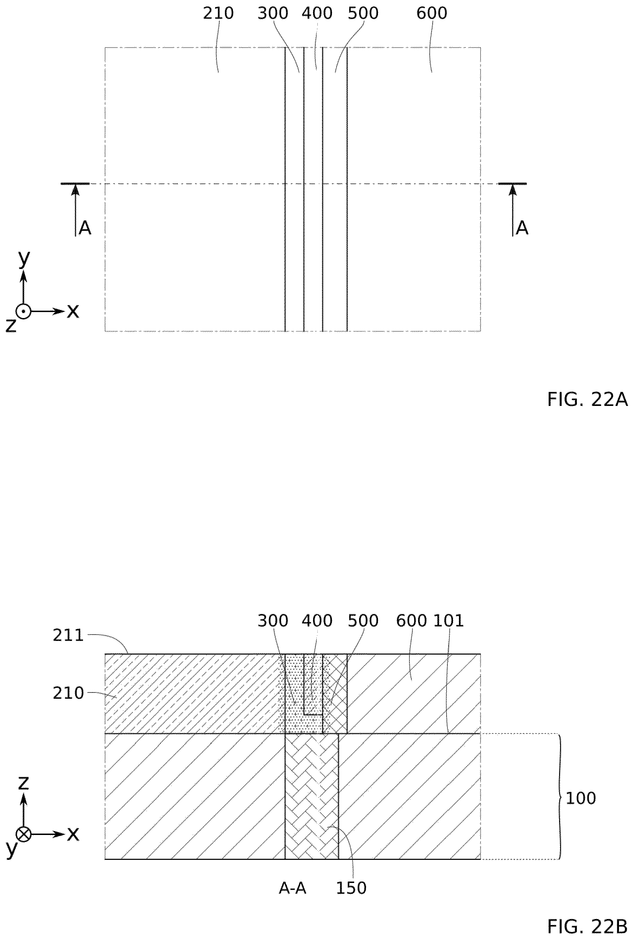

La couche de remplissage 600 présente une face supérieure 601 s'étendant principalement dans un plan parallèle au plan longitudinal XY. Le dépôt de cette couche de remplissage 600 permet ainsi de créer une face continue et sensiblement plane à partir de laquelle réaliser une étape de polissage représentée par le passage des figures 21A et 21B aux figures 22A et 22B.

Cette étape de polissage est de préférence réalisée par polissage mécano-chimique (couramment désigné CMP, abréviation anglaise de « Chemical Mechanical Polishing »). Le polissage est de préférence configuré pour s'arrêter sélectivement sur la face supérieure 211 de la première couche diélectrique 210, après avoir entièrement retiré la deuxième couche diélectrique 220, une portion de la paroi 3000, une portion de la portion principale 410b de la première couche d'encapsulation 400 et une portion la portion principale 510b de la deuxième couche d'encapsulation 500, toutes ces portions s'étendant au-dessus, selon la direction d'empilement Z, du plan dans lequel s'étend principalement la face supérieure 211 de la première couche diélectrique 210. Si elle n'a pas été retirée précédemment, la première portion 500a de la deuxième couche d'encapsulation 500 peut être retirée par cette étape de polissage.

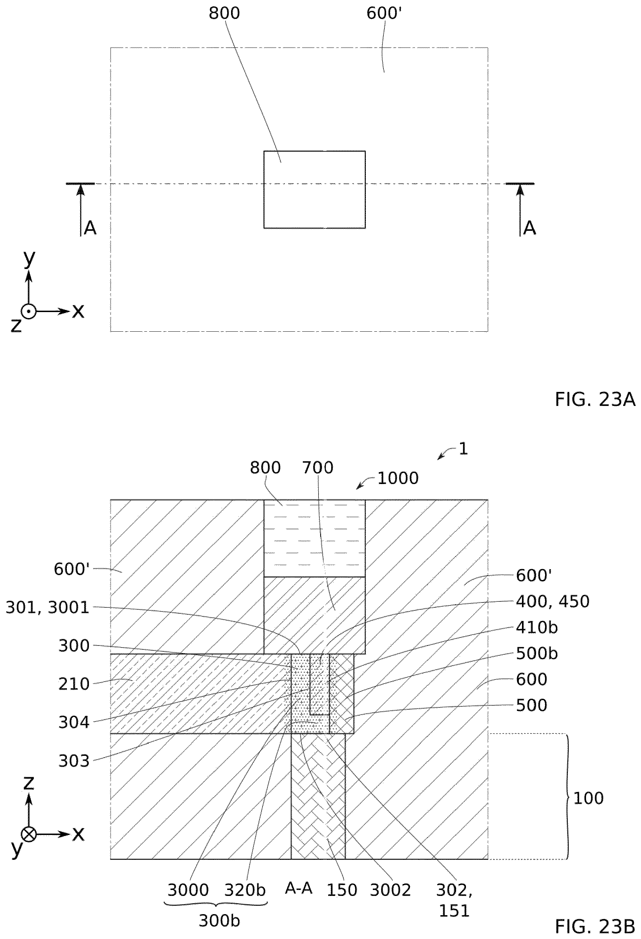

Les figures 23A et 23B illustrent la formation sur la paroi 3000 - et, avantageusement, également sur les couches d'encapsulation 400, 500 - d'une couche mémoire 700 et d'une électrode supérieure 800. Une couche de remplissage secondaire 600' peut également être formée autour de ces éléments, sur la couche de remplissage 600 et sur la première couche support 210. La couche de remplissage secondaire 600' peut par exemple être à base de SiO₂.

L'ensemble comprenant la couche métallique 300, la couche mémoire 700 et l'électrode supérieure 800 forme un point mémoire 1000.

Les caractéristiques structurelles de ce point mémoire 1000 seront décrites plus en détails plus avant.

### Etape d'implantation

Le procédé selon l'invention prévoit au moins une étape d'implantation visant à implanter avec une espèce dopante a minima la première couche d'encapsulation 400, et de préférence également la portion de la couche métallique 300 qui deviendra l'élément chauffant du dispositif mémoire 1 fabriqué par le procédé. Les paragraphes suivants visent à décrire plus précisément cette étape d'implantation.

L'espèce dopante implantée lors de cette étape peut être l'une parmi les espèces suivantes : l'argon, le carbone, l'azote, le silicium, le xénon, le titane, le tantale, le tungstène, le germanium, l'oxygène, le cobalt et le néon. Plusieurs de ces espèces peuvent être implantées.

L'implantation est typiquement réalisée à une énergie comprise entre 1 et 500 KeV, par exemple à 12 keV.

L'implantation est de préférence configurée pour que la première couche d'encapsulation 400 soit dopée sur une portion 450 présentant une épaisseur e₄₅₀ avec e₄₅₀ ≥ 0,05*e₄₀₀, et de préférence e₄₅₀ ≥ 0,10*e₄₀₀.

L'implantation est par ailleurs de préférence configurée pour que l'élément chauffant 3000 soit implanté sur toute son épaisseur e_{ec}, typiquement égale à e₃₀₀₀, décrite plus avant.

Dans tous les modes de réalisation de l'implantation envisagés ci-dessous, l'implantation est réalisée selon un angle d'implantation αᵢₘₚₗ mesuré par rapport au plan dans lequel s'étend principalement le premier flanc principal 303 de la couche métallique 300. αᵢₘₚₗ est donc typiquement mesuré par rapport au plan transversal YZ. αᵢₘₚₗ est notamment ajusté en fonction de l'espacement entre les points mémoires 1000 formés simultanément par le procédé selon l'invention. Ainsi, plus les points mémoires 1000 sont resserrés, plus αᵢₘₚₗ devra être faible. Typiquement, αᵢₘₚₗ est compris entre 15° et 75°, de préférence entre 25° et 45°.

Avant l'étape d'implantation, la couche métallique 300 présente une résistivité électrique supérieure à 10² µΩ.cm, voire supérieure à 10³ µΩ.cm, et typiquement inférieure à 10⁴ µΩ.cm. Après l'étape d'implantation, lorsque celle-ci vise également la couche métallique 300, cette dernière présente de préférence une résistivité électrique inférieure à 10³ µΩ.cm.

L'empilement fourni en début du procédé selon l'invention correspond à l'un quelconque des empilements illustrés aux figures 9, 12, 15 et 18.

Il est parfaitement envisageable que l'étape d'implantation soit constituée de plusieurs sous-étapes d'implantation, chaque sous-étape d'implantation correspondant à l'une des étapes d'implantation décrites ci-dessous. Par exemple, on peut prévoir une sous-étape d'implantation entre la formation de la couche métallique 300 et la formation de la première couche d'encapsulation 400, afin d'implanter la couche métallique et éventuellement la première couche diélectrique 210, puis une sous-étape d'implantation entre la formation de la première couche d'encapsulation 400 et la formation de la deuxième couche d'encapsulation 500, afin d'implanter la première couche d'encapsulation 400 et éventuellement les couches qu'elle recouvre (couche métallique 300, première couche diélectrique 210).

Il est également possible que plusieurs implantations soient réalisées successivement, par exemple pour implanter plusieurs espèces dopantes au niveau de la ou des mêmes couches.

Selon un mode de réalisation, l"implantation de la première couche d'encapsulation 400 est réalisée avant (figures 10B et 13B) l'étape de formation de la deuxième couche d'encapsulation 500. Selon un autre mode de réalisation, elle est réalisée après (figures 16B et 19B). Elle peut avoir lieu en même temps que l'implantation d'autres couches, et notamment en même temps que l'implantation de la couche métallique 300 et éventuellement que l'implantation de la deuxième couche d'encapsulation 500 (voir les modes de réalisation décrits plus avant).

Comme mentionné précédemment, la couche métallique 300 est de préférence également implantée.

Selon un mode de réalisation illustré à la figure 7B, l'implantation de la couche métallique 300 a lieu lorsque son premier flanc principal 303 n'est pas recouvert. Autrement dit, dans ce mode de réalisation, le premier flanc principal 303 de la couche métallique 300 est laissé libre. L'étape d'implantation de la couche métallique 300 est donc effectuée avant l'étape de formation de la première couche d'encapsulation 400 (et, si elle est réalisée, avant l'étape de formation de la deuxième couche d'encapsulation 500).

Selon un autre mode de réalisation, l'étape d'implantation de la couche métallique 300 est effectuée après l'étape de formation de la première couche d'encapsulation 400 et, si elle est effectuée, avant l'étape de formation de la deuxième couche d'encapsulation 500. Dans ce cas, l'implantation de l'élément chauffant 3000 du dispositif 1 est donc réalisée à travers la première couche d'encapsulation 400. Selon un exemple de ce mode de réalisation, l'implantation est effectuée avant le retrait partiel de la couche métallique 300 et de la première couche d'encapsulation 400 décrit plus haut (figures 10B, 11B). Selon un autre exemple, l'implantation est réalisée après ce retrait partiel (figures 13B, 14B).

Dans ce mode de réalisation, la première couche d'encapsulation 400, et notamment sa portion principale 410b, est également implantée. On prévoit que cette implantation soit effective dans au moins une portion dite portion dopée 450 de la portion principale 410b de la première couche d'encapsulation 400, et que cette portion dopée 450 présente de préférence une concentration en espèce dopante supérieure ou égale à 5.10²⁰ atomes/cm³. Cette portion dopée 450 s'étend depuis le premier flanc principal 303 de la couche métallique 300 (voir figures 11B et 14B).

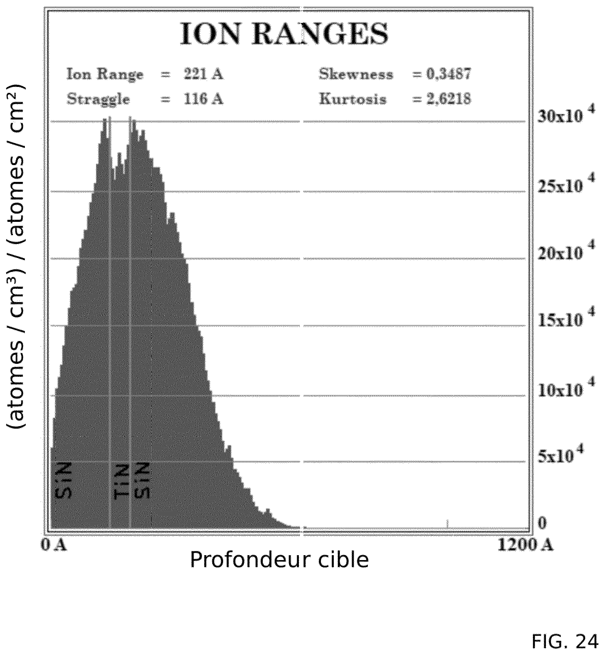

La figure 24 représente le résultat d'une simulation logicielle de l'implantation en carbone d'une tri-couche SiN/TiN/SiN. Dans cette simulation, la première couche de SiN peut être assimilée à la première couche diélectrique 210, la couche de TiN à l'élément chauffant 3000 et la deuxième couche de SiN à la première couche d'encapsulation 400. Les paramètres ont été réglés de sorte à simuler une implantation à 12 keV d'une dose de 10¹⁶ at.cm² centrée dans l'élément chauffant et également effective dans les portions voisines de la couche diélectrique et de la première couche d'encapsulation, à αᵢₘₚₗ=45°. On observe qu'une telle implantation engendre un pic de carbone dans l'élément chauffant 3000 à une concentration de plus de 25.10²⁰ atomes/cm³. On constate également la création d'un gradient dans chacune des couches de SiN depuis l'interface avec l'élément chauffant. Ce gradient s'étend sur une vingtaine de nanomètres environ.

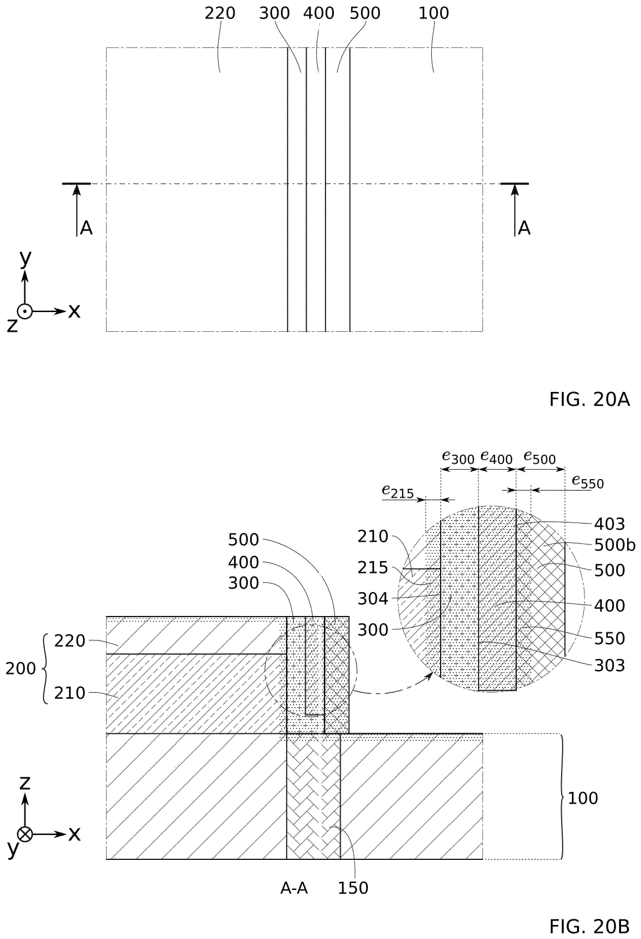

Selon un autre mode de réalisation, l'étape d'implantation de la couche métallique 300 est effectuée après l'étape de formation de la première couche d'encapsulation 400 et après l'étape de formation de la deuxième couche d'encapsulation 500. Dans ce cas, l'implantation de l'élément chauffant 3000 du dispositif 1 est donc réalisée à travers la deuxième couche d'encapsulation 500 et à travers la première couche d'encapsulation 400. Selon un exemple de ce mode de réalisation, l'implantation est effectuée avant le retrait partiel de la deuxième couche d'encapsulation 500 décrit plus haut (figures 16B, 17B). Selon un autre exemple, l'implantation est réalisée après ce retrait partiel (figures 19B, 20B) sur une épaisseur e₄₅₀ prise perpendiculairement à ce même flanc 303.

Dans ce mode de réalisation, la première couche d'encapsulation 400 est également implantée, de préférence sur toute son épaisseur e₄₀₀. La deuxième couche d'encapsulation 500, et notamment sa deuxième portion 500b, est également implantée. On prévoit qu'au moins une portion dite portion dopée 550 de la deuxième portion 500b de la deuxième couche d'encapsulation 500 présente une concentration en espèce dopante supérieure ou égale à 1.10²⁰ atomes/cm³.Cette portion dopée 550 s'étend depuis le premier flanc principal 403 de la première couche d'encapsulation 500 (voir figures 17B et 14B) sur une épaisseur e₅₅₀ prise perpendiculairement à ce même flanc 403.

Par souci de clarté et notamment pour distinguer les différents moments du procédé auxquels l'implantation peut être réalisée, le dopage issu des implantations illustrées aux figures 7, 10, 13, et 16 ne sont illustrés qu'aux figures 8, 11, 14 et 17, respectivement. Le dopage issu de l'implantation illustrée à la figures 19 est, lui, illustré jusqu'à la figure 23.

Il est entendu que toutes les étapes décrites précédemment permettant d'aboutir au point mémoire 1000 peuvent être réalisées, de préférence simultanément, au-dessus de différentes zones du support 100 afin de fabriquer une pluralité de points mémoires 1000.

Comme explicité précédemment, il s'est avéré qu'en effectuant une étape d'implantation dans la première couche d'encapsulation, sa stœchiométrie et sa structure atomique sont modifiées, ce qui a pour effet de réduire son coefficient de transfert thermique. Cela provoque un effet de confinement thermique de l'élément chauffant, et la chaleur émanant de ce dernier est ainsi plus dissipée vers la couche mémoire 700 que dans les autres régions environnantes. L'implantation a ainsi pour effet d'améliorer le ratio entre l'énergie apportée à l'élément chauffant et l'énergie effectivement utile à la programmation de l'état de la couche mémoire 700.

Comme décrit en détail précédemment, il s'est par ailleurs avéré qu'en implantant également la couche métallique 300, sa stœchiométrie et sa structure atomique sont modifiées et de nouveaux éléments chimiques sont ajoutés dans cette même couche. De façon inattendue, cela a pour effet d'améliorer la tenue en température de l'élément chauffant 3000. Cela est particulièrement vrai lorsque l'implantation est réalisée au travers de la voire des deux couche(s) d'encapsulation 400, 500, car alors des espèces sont transférées depuis ces couches vers l'élément chauffant 3000.

Par ailleurs, l'implantation permet d'améliorer la résistivité de l'élément chauffant 3000. Cela induit un effet Joule plus fort au sein de l'élément chauffant 3000 et donc un meilleur contrôle de la programmation de l'état de la couche mémoire 700. Cette augmentation de la couche métallique 300 est notamment due à l'amorphisation de cette dernière lors de l'implantation.

### Dispositif mémoire à changement de phase

Un autre objet de l'invention concerne le dispositif 1 pouvant être obtenu par l'un quelconque des modes de réalisation du procédé décrits précédemment.

### Structure WALL

Un mode de réalisation particulier du dispositif 1 va maintenant être décrit en référence à la figure 23. Ce mode de réalisation porte sur un point mémoire de type WALL. Il est entendu cependant que d'autres types de structures peuvent être envisagées. Ces autres structures seront décrites plus avant.

La figure 23 illustre un unique point mémoire 1000 du dispositif 1 selon l'invention, mais il est entendu que le dispositif 1 peut en comprendre plusieurs.

Le point mémoire 1000 comprend une couche métallique 300 à base d'un matériau métallique. La couche métallique 300 comprend typiquement une paroi 3000 et un retour 320b. La paroi 3000 s'étend entre un premier flanc principal 303 et un deuxième flanc principal 304 de la couche métallique 300. La paroi 3000 et le retour 320b forment ensemble un coude, pouvant également être désigné « L ». Le retour 320b est cependant optionnel. La couche métallique 300 peut ne comprendre que la paroi 3000.

Le premier flanc principal 303 et le deuxième flanc principal 304 de la couche métallique 300 s'étendent de préférence parallèlement à la deuxième direction Y et à la direction d'empilement Z.

La couche métallique 300 présente une face supérieure 301 et une face inférieure 302 opposées l'une à l'autre et s'étendant chacune sensiblement dans un plan parallèle au plan longitudinal XY. La couche métallique 300 s'étend intégralement entre sa face supérieure 301 et sa face inférieure 302.

La paroi 3000 présente une face supérieure 3001 et une face inférieure 3002 opposées l'une à l'autre et s'étendant chacune sensiblement dans un plan parallèle au plan longitudinal XY. La face supérieure 301 de la couche métallique 300 et la face supérieure 3001 de la paroi 3000 d'une part et la face inférieure 302 de la couche métallique 300 et la face inférieure 3002 de la paroi 3000 d'autre part sont de préférence confondues. Autrement dit, de préférence, la paroi 3000 s'étend sur toute la hauteur de la couche métallique 300.

Le point mémoire 1000 comprend en outre, sur la face supérieure 301 de la couche métallique 300, une couche mémoire 700 à base d'un matériau à changement de phase.

Par exemple, la couche mémoire 700 peut-être à base ou faite de tout matériau appartenant au diagramme ternaire du germanium Ge, antimoine Sb et tellure Te. Par exemple, ce matériau est choisi parmi Ge1Sb2Te4, GeTe, Sb2Te3, Ge7Sb1Te2. La couche mémoire 700 peut également être à base ou faite d'un alliage d'un matériau du diagramme ternaire de Ge, Sb et Te et d'un ou plusieurs élément(s) parmi les suivants : Si, As, Se, N, S, In, Ga, Bi.

La couche mémoire 700 présente une face supérieure 701 et une face inférieure 702 opposées l'une à l'autre et s'étendant chacune dans un plan perpendiculaire à la direction d'empilement Z. La face supérieure 701 et la face inférieure 702 de la couche mémoire 700 sont également désignées faces principales 701, 702 de la couche mémoire.

Le point mémoire 1000 comprend en outre, sur la face supérieure 701 de la couche mémoire 700, une électrode dite supérieure 800.

La paroi 3000 constitue l'élément chauffant 3000 du point mémoire 1000.

L'élément chauffant 3000 est thermiquement couplé à la couche mémoire 700 de sorte à ce qu'une partie au moins de la chaleur produite par l'élément chauffant 3000 par effet Joule soit transférée, par conduction, à la couche mémoire 700. De préférence, l'élément chauffant 3000 est au contact de la couche mémoire 700.

Les paragraphes suivants donnent des précisions sur les dimensions typiques de l'élément chauffant et de la couche mémoire 700 dans le cas d'une structure WALL telle que représentée à la figure 23B.

L'élément chauffant 3000 présente une épaisseur e_{ec}, prise perpendiculairement à ses flancs principaux 303, 304. Cette épaisseur est ainsi mesurée selon la première direction X sur les figures. Typiquement, e_{ec} est supérieure à 1 nm, de préférence inférieure à 50 nm, de préférence inférieure à 10 nm. Par exemple, e_{ec} est sensiblement égale à 5 nm.

L'élément chauffant 3000 présente par ailleurs une hauteur h_{ec} prise le long du deuxième flanc principal 304, selon la direction d'empilement Z.

L'élément chauffant 3000 est configuré de sorte que h_{ec} > α * e_{ec}, avec α > 2, de préférence α > 5. Ainsi, l'élément chauffant 3000 présente une hauteur h_{ec}, selon la direction Z importante relativement à son épaisseur e_{ec} selon la direction X.

L'élément chauffant 3000 présente en outre une largeur l_{ec}, mesurée perpendiculairement à h_{ec} et à e_{ec}.

Selon un mode de réalisation, l_{ec} > δ * e_{ec}, avec δ > 2, de préférence δ > 5. Ainsi, l'élément chauffant 3000 présente une largeur l_{ec}, selon la direction Y importante relativement à son épaisseur e_{ec} selon la direction X.

Avec ces dimensions relatives h_{ec}, l_{ec}, et e_{ec}, l'élément chauffant 3000 présente une forme de paroi qui peut être qualifiée de mur ou de wall en anglais.

La couche mémoire 700 présente une épaisseur e_{cm}, mesurée perpendiculairement aux faces principales 701, 702 de la couche mémoire 700 et d'une face principale à l'autre. Ainsi, e_{cm} est mesurée selon la même direction que h_{ec}. Typiquement, e_{cm} est supérieure à 5 nm, de préférence inférieure à 200 nm, par exemple égale à 50 nm.

La couche mémoire 700 présente en outre une longueur L_{cm} et une largeur l_{cm} mesurées perpendiculairement à e_{cm} et perpendiculairement l'une à l'autre. L_{cm} est mesurée selon la même direction que e_{ec} et l_{cm} est mesurée selon la même direction que l_{ec}.

Le dispositif 1 est avantageusement configuré de sorte que h_{ec} > β * e_{cm}, avec β > 2, de préférence β > 5, de préférence β > 10.

Le dispositif 1 est avantageusement configuré de sorte que L_{cm} > γ * e_{ec}, avec γ > 2, de préférence γ > 5, de préférence γ > 10. Cela permet de concentrer la transmission de la chaleur émise par effet Joule à une zone réduite de la couche mémoire 700. En effet, pour que le point mémoire 1000 soit fonctionnel, il suffit qu'une conduction électrique soit créée entre les faces principales 701, 702 de la couche mémoire 700. Cela peut être obtenu par un changement d'état du matériau à changement de phase dans une portion réduite de la couche mémoire 700 uniquement. En concentrant l'impact de l'effet Joule sur une portion réduite de la couche mémoire 700, on maximise le rendement du point mémoire 1000.

La paroi 3000 peut s'étendre sur toute la largeur l_{cm} de la couche mémoire 700 (l_{ec}=l_{cm}), ou bien être moins large que la couche mémoire 700 (l_{ec}<l_{cm}).

Comme mentionné précédemment, le point mémoire 1000 peut également présenter d'autres types de structures. Différents exemples de structures envisageables sont présentés ci-dessous.

### Structure dite « en anneau »

Un deuxième exemple de structure est illustré à la figure 25A. Dans cet exemple, la couche métallique 300 diffère de l'exemple décrit en référence à la figure 23B en ce qu'elle forme un contour fermé en projection dans le plan longitudinal XY. Notamment, le premier flanc principal 303 et le deuxième flanc principal 304 de la couche métallique 300 forment de préférence chacun un contour fermé, de préférence circulaire, en projection dans le plan longitudinal XY. La couche métallique 300 peut notamment entourer la couche diélectrique 210, qui peut présenter une forme cylindrique, de préférence circulaire. La couche métallique 300 présente de préférence une base 310 dont les faces principales s'étendent parallèlement au plan longitudinal XY. La base 310 de la couche métallique 300 est destinée à être mise en contact avec un via métallique. La couche métallique 300 est de préférence affleurante à la face supérieure 401 de la première couche d'encapsulation 400 et à la face supérieure 211 de la première couche diélectrique 210.

Dans cet exemple, la couche mémoire 700 se trouve au-dessus de la couche métallique 300, de la première couche support 210 et de la première couche d'encapsulation 400.

Du fait de la forme de la couche métallique 300, cette structure peut être désignée structure « en anneau », ou en anglais « ring ».

Dans le cas d'une structure en anneau, l'implantation peut par exemple être réalisée après la formation de la première couche d'encapsulation 400, de la couche métallique 300 et d'une portion de la première couche d'arrêt 210 déposée contre le deuxième flanc principal 304. L'implantation est alors de préférence paramétrée pour être effective dans une portion 450 de la première couche d'encapsulation 400, dans la couche métallique 300 et dans la portion de la première couche d'arrêt 210 déjà déposée. La cavité définie par la couche métallique 300 peut ensuite être terminée d'être remplie par la première couche d'arrêt 210. La couche mémoire 700 peut ensuite être formée au-dessus de la couche métallique 300, de la première couche d'encapsulation 400 et de la première couche diélectrique 210.

### Structure dite « en anneau confiné »

Un troisième exemple de structure est illustré à la figure 25B. Cette structure est très proche de la structure précédemment décrite. Elle en diffère cependant en ce que la couche mémoire 700 forme un contour fermé en projection dans le plan longitudinal XY. Elle se situe selon la direction d'empilement Z dans le prolongement de la couche métallique 300. Elle sépare dans le plan longitudinal XY la première couche d'encapsulation 400 de la première couche diélectrique 210. C'est cette fois la couche mémoire 700 qui est de préférence affleurante à la face supérieure 401 de la première couche d'encapsulation 400 et à la face supérieure 211 de la première couche diélectrique 210.

Cette structure diffère donc de la précédente en ce que la couche mémoire 700 est logée entre la première couche d'encapsulation 400 et la première couche diélectrique 210. Pour cette raison, cette structure peut être désignée structure « en anneau confiné ».

L'implantation d'une structure en anneau confiné peut être réalisée de la même manière que dans le cas d'une structure en anneau. Une étape de retrait d'une portion supérieure de la couche métallique 300 sera cependant prévue en plus afin d'aménager entre la première couche d'encapsulation 400 et la première couche support 210 une ouverture dans laquelle la couche mémoire 700 sera ensuite formée.

### Structure dite « en anneau avec micro-tranchée »

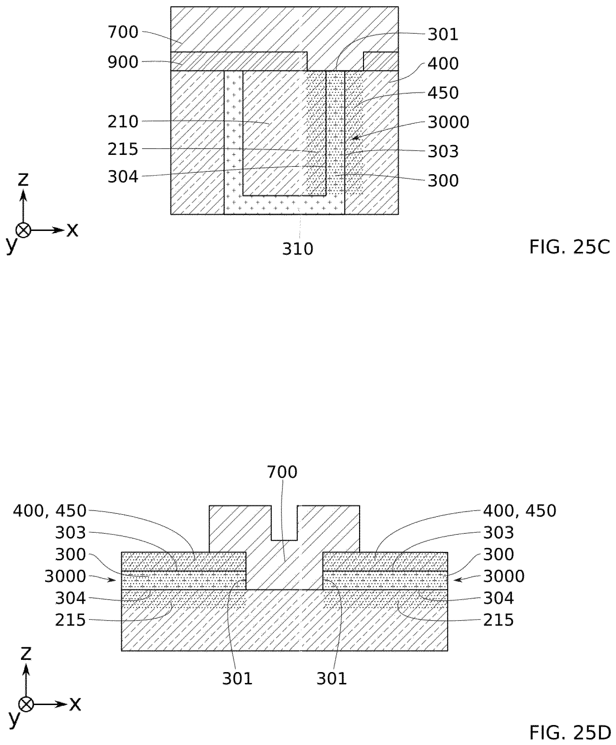

Un quatrième exemple de structure est illustré à la figure 25C. Cet exemple se différencie du deuxième exemple en ce qu'une couche diélectrique 900 sépare partiellement la couche métallique 300 et la couche mémoire 700. Le contact entre ces deux couches se fait sur une portion seulement du contour défini par la couche métallique 300. La couche mémoire 700 s'étend au-dessus de la couche diélectrique 900 ainsi que dans une ouverture traversante aménagée dans la couche diélectrique 900, pouvant être désignée tranchée. Cette tranchée débouche sur la couche métallique 300 et permet ainsi le contact entre la couche mémoire 700 et la couche métallique 300.

Cette structure peut être désignée structure « en anneau avec micro-tranchée ».

L'implantation d'une structure en anneau avec micro-tranchée peut être réalisée de la même manière que dans le cas d'une structure en anneau. Une étape de dépôt de la couche diélectrique 900 sera cependant prévue en plus avant la formation de la couche mémoire 700.

### Structure dite « pont »

Un cinquième exemple de structure est illustré à la figure 25D. Les flancs principaux 303, 304 de la couche métallique 300 s'étendent dans cet exemple dans des plans sensiblement parallèles au plan longitudinal XY. La couche métallique 300 comprend par ailleurs de préférence deux portions, séparées l'une de l'autre par la couche mémoire 700. De préférence, la couche mémoire 700 s'étend également au-dessus de la première couche d'encapsulation 400. Cette structure peut être désignée structure « pont ».

Il est possible, pour former le dispositif 1 selon cet exemple de réalisation de l'invention, de fournir un empilement comprenant la première couche diélectrique 210, la couche métallique 300 et la première couche d'encapsulation 400, de réaliser une implantation de la première couche d'encapsulation 400 (ainsi de préférence que de la couche métallique 300 et de la première couche diélectrique 210), puis de former une ouverture dans la première couche d'encapsulation 400 et dans la couche métallique 300 et enfin de former la couche mémoire 700 au moins partiellement dans cette ouverture.

A travers les différents modes de réalisation décrits ci-dessus, il apparaît clairement que l'invention propose une solution efficace pour améliorer la tenue en température de l'élément chauffant d'un dispositif mémoire de type PCM. L'invention permet en outre d'améliorer la résistivité de cet élément, et, dans les modes de réalisation prévoyant la présence d'une ou plusieurs couches d'encapsulation contre l'élément chauffant, d'améliorer son confinement thermique.

L'invention n'est pas limitée aux modes de réalisations précédemment décrits et s'étend à tous les modes de réalisation couverts par les revendications.

## Revendications

1. Dispositif mémoire à changement de phase (1) comprenant un point mémoire (1000), le point mémoire (1000) comprenant :
• une couche métallique (300) à base d'un matériau métallique et formant un élément chauffant (3000),
• une couche mémoire (700) à base d'un matériau à changement de phase, le matériau à changement de phase étant configuré de sorte que la couche mémoire (700) passe sélectivement d'un premier état résistif (LRS) présentant une première résistivité à un deuxième état résistif (HRS) présentant une deuxième résistivité supérieure à la première résistivité (LRS),
• une électrode supérieure (800),
l'élément chauffant (3000) étant destiné à recevoir un courant électrique permettant de produire de la chaleur par effet Joule et à transférer une partie de cette chaleur à la couche mémoire (700) de sorte à faire passer sélectivement la couche mémoire (700) de l'un parmi le premier état résistif (LRS) et le deuxième état résistif (HRS), vers l'autre parmi le premier état résistif (LRS) et le deuxième état résistif (HRS),
l'élément chauffant (3000) présente un premier flanc principal (303) et un deuxième flanc principal (304), opposés l'un à l'autre, le dispositif mémoire comprenant en outre une première couche d'encapsulation (400) s'étendant depuis le premier flanc principal (303) de la couche métallique (300),
**caractérisé en ce que** la première couche d'encapsulation (400) présente une portion (450), dite dopée, présentant un dopage à base d'au moins une espèce, dite première espèce dopante, la portion dopée (450) s'étendant depuis le premier flanc principal (303) de la couche métallique (300), et **en ce que** la couche métallique (300) présente un dopage à base d'une deuxième espèce dopante, de préférence identique à la première espèce dopante.

2. Dispositif (1) selon la revendication précédente dans lequel la concentration en espèce dopante dans la portion dopée (450) est supérieure ou égale à 5.10²⁰ atomes/cm³, de préférence supérieure ou égale à 1.10²¹ atomes/cm³.

3. Dispositif (1) selon l'une quelconque des revendications précédentes dans lequel la première couche d'encapsulation (400) présente une épaisseur e₄₀₀ prise selon une direction perpendiculaire au premier flanc principal (303) de la couche métallique (300), la portion dopée (450) s'étendant sur une épaisseur e₄₅₀ selon cette même direction au sein de la première couche d'encapsulation (400), avec e₄₅₀ ≥ 0,05*e₄₀₀, de préférence e₄₅₀ ≥ 0,10*e₄₀₀.

4. Dispositif (1) selon l'une quelconque des revendications précédentes dans lequel la couche métallique (300) présente une épaisseur e₃₀₀ entre son premier flanc principal (303) et son deuxième flanc principal (304), avec e₃₀₀ ≤ 10 nm.

5. Dispositif (1) selon l'une quelconque des revendications précédentes dans lequel le premier flanc principal (303) de la couche métallique (300) est intégralement dopé, de préférence uniformément.

6. Dispositif (1) selon l'une quelconque des revendications précédentes comprenant en outre une première couche diélectrique (210) s'étendant contre le deuxième flanc principal (304) de la couche métallique (300), la première couche diélectrique (210) présentant une portion (215), dite dopée, présentant un dopage à base d'au moins une espèce, dite troisième espèce dopante, de préférence identique à la première espèce dopante, la portion dopée (215) de la première couche diélectrique (210) s'étendant depuis le deuxième flanc principal (304) de la couche métallique (300).

7. Dispositif (1) selon l'une quelconque des revendications précédentes dans lequel la première espèce dopante est choisie parmi les espèces suivantes : le silicium, le carbone, l'argon, l'azote, le xénon, le titane, le tantale, le tungstène, le germanium, l'oxygène, le cobalt, le néon et leurs alliages.

8. Dispositif (1) selon l'une quelconque des revendications précédentes dans lequel le matériau métallique est à base d'au moins un parmi les matériaux suivants : TiN, TiC, TiSiN, TiSiCN, TiWN, TaN, TaCN.

9. Procédé de fabrication d'un dispositif mémoire à changement de phase (1) comprenant un point mémoire (1000), le procédé comprenant les étapes suivantes :
• fournir un ensemble comprenant au moins :
i. une couche métallique (300) à base d'un matériau métallique et destinée à former un élément chauffant (3000) pour le point mémoire (1000), la couche métallique (300) présentant un premier flanc principal (303),
ii. une première couche d'encapsulation (400) s'étendant depuis le premier flanc principal (303) de la couche métallique (300),
• implanter une espèce dite première espèce dopante dans une portion (450), dite dopée, de la première couche d'encapsulation (400), la portion dopée (450) s'étendant depuis le flanc principal (303) de la couche métallique (300),
• implanter une espèce dite deuxième espèce dopante, de préférence identique à la première espèce dopante, dans la couche métallique (300), au travers de la première couche d'encapsulation (400),
• former contre une face (301) de la couche métallique (300) un empilement comprenant :
i. une couche dite couche mémoire (700) à base d'un matériau à changement de phase, couplée thermiquement avec la couche métallique (300) de sorte que de la chaleur produite par effet Joule par la couche métallique (300) soit transférée à la couche mémoire (700),
ii. une électrode supérieure.

10. Procédé selon la revendication précédente dans lequel la première espèce dopante est choisie parmi les espèces suivantes : le silicium, le carbone, l'argon, l'azote, l'oxygène, le xénon, le titane, le tantale, le tungstène, le germanium, le cobalt, le néon et leurs alliages.

11. Procédé selon l'une quelconque des deux revendications précédentes dans lequel la première couche d'encapsulation (400) est à base d'au moins un parmi les matériaux suivants : SiN, SiCN, SiC.

12. Procédé selon l'une quelconque des trois revendications précédentes dans lequel la première couche d'encapsulation (400) présente un premier flanc principal (403) et un deuxième flanc principal (404) opposés l'un à l'autre, le deuxième flanc principal (404) étant en regard du premier flanc principal (303) de la couche métallique (300), le procédé comprenant en outre la formation d'une deuxième couche d'encapsulation (500) contre le premier flanc principal (403) de la première couche d'encapsulation (400), et dans lequel l'implantation de la deuxième espèce dopante dans la couche métallique (300) est réalisée au travers de la deuxième couche d'encapsulation (500).

13. Procédé selon l'une quelconque des quatre revendications précédentes dans lequel la fourniture de l'ensemble comprend les étapes suivantes :
• fournir une couche support (100) présentant une face supérieure (101) s'étendant principalement dans un plan parallèle au plan longitudinal (XY),
• former sur une portion de la face supérieure (101) de la couche support (100) une couche diélectrique (200), la couche diélectrique (200) présentant un flanc (203) s'étendant de préférence principalement dans un plan parallèle au plan transversal (YZ),
• former au moins contre le flanc (203) de la couche d'appui (200), et de préférence sur la face supérieure (101) de la couche support (100), la couche métallique (300).

14. Procédé selon la revendication précédente dans lequel la couche diélectrique (200) comprend une première couche diélectrique (210) et une deuxième couche diélectrique (220), la deuxième couche diélectrique (220) et la couche support (100) étant séparées par la première couche diélectrique (210), le procédé comprenant en outre une étape de polissage d'une portion de la couche métallique (300) et de la deuxième couche diélectrique (220), avec un arrêt sélectif sur la première couche diélectrique (210).

## Patentansprüche

1. Phasenwechselspeichervorrichtung (1), die einen Speicherpunkt (1000) umfasst, wobei der Speicherpunkt (1000) Folgendes umfasst:
• eine metallische Schicht (300), die auf einem metallischen Material basiert und ein Heizelement (3000) bildet,
• eine Speicherschicht (700), die auf einem Phasenwechselmaterial basiert, wobei das Phasenwechselmaterial dazu konfiguriert ist, dass die Speicherschicht (700) selektiv von einem ersten Widerstandszustand, der eine erste Resistivität aufweist, auf einen zweiten Widerstandszustand (HRS) übergeht, der eine zweite Resistivität aufweist, die größer ist als die erste Resistivität (LRS),
• eine obere Elektrode (800),
wobei das Heizelement (3000) dazu bestimmt ist, einen elektrischen Strom zu empfangen, der es erlaubt, Wärme durch Joule-Effekt zu erzeugen und einen Teil dieser Wärme an die Speicherschicht (700) zu transferieren, sodass die Speicherschicht (700) selektiv von einem des ersten Widerstandszustands (LRS) und des zweiten Widerstandszustands (HRS) auf den anderen des ersten Widerstandszustands (LRS) und des zweiten Widerstandszustands (HRS) übergeht,
wobei das Heizelement (3000) eine erste Hauptflanke (303) und eine zweite Hauptflanke (304) aufweist, die einander entgegengesetzt sind, wobei die Speichervorrichtung außerdem eine erste Kapselungsschicht (400) umfasst, die sich von der ersten Hauptflanke (303) der metallischen Schicht (300) erstreckt,
**dadurch gekennzeichnet, dass** die erste Kapselungsschicht (400) einen Abschnitt (450) aufweist, der als dotiert bezeichnet wird, der eine Dotierung basierend auf mindestens einer Spezies aufweist, als erste dotierende Spezies bezeichnet, wobei sich der dotierende Abschnitt (450) von der ersten Hauptflanke (303) der metallischen Schicht (300) erstreckt, und dass die metallische Schicht (300) eine Dotierung basierend auf einer zweiten dotierenden Spezies aufweist, die bevorzugt mit der ersten dotierenden Spezies identisch ist.

2. Vorrichtung (1) nach dem vorstehenden Anspruch, wobei die Konzentration an dotierender Spezies in dem dotierten Abschnitt (450) größer oder gleich 5.10²⁰ Atome/cm³ ist, bevorzugt größer oder gleich 1.10²¹ Atome/cm³.

3. Vorrichtung (1) nach einem der vorstehenden Ansprüche, wobei die erste Kapselungsschicht (400) eine Dicke e₄₀₀ entlang einer Richtung senkrecht zu der ersten Hauptflanke (303) der metallischen Schicht (300) aufweist, sich der dotierte Abschnitt (450) auf einer Dicke e₄₅₀ entlang derselben Richtung innerhalb der ersten Kapselungsschicht (400) erstreckt, wobei e₄₅₀ ≤ 0,05*e₄₀₀, bevorzugt e₄₅₀ ≤ 0,10* e₄₀₀.

4. Vorrichtung (1) nach einem der vorstehenden Ansprüche, wobei die Metallschicht (300) eine Dicke e₃₀₀ zwischen ihrer ersten Hauptflanke (303) und ihrer zweiten Hauptflanke (304) aufweist, wobei e₃₀₀ ≤ 10 nm.

5. Vorrichtung (1) nach einem der vorstehenden Ansprüche, wobei die erste Hauptflanke (303) der metallischen Schicht (300) integral dotiert, bevorzugt gleichmäßig dotiert ist.

6. Vorrichtung (1) nach einem der vorstehenden Ansprüche, die außerdem eine erste dielektrische Schicht (210) umfasst, die sich gegen die zweite Hauptflanke (304) der metallischen Schicht (300) erstreckt, wobei die erste dielektrische Schicht (210) einen Abschnitt (215) aufweist, der als dotiert bezeichnet wird, der eine Dotierung basierend auf mindestens einer Spezies aufweist, die als dritte dotierende Spezies bezeichnet wird, die bevorzugt mit der ersten dotierenden Spezies identisch ist, wobei sich der dotierte Abschnitt (215) der ersten dielektrischen Schicht (210) von der zweiten Hauptflanke (304) der metallischen Schicht (300) erstreckt.

7. Vorrichtung (1) nach einem der vorstehenden Ansprüche, wobei die erste dotierende Spezies aus den folgenden Spezies ausgewählt wird: Silizium, Kohlenstoff, Argon, Stickstoff, Xenon, Titan, Tantal, Wolfram, Germanium, Sauerstoff, Kobalt, Neon und deren Legierungen.

8. Vorrichtung (1) nach einem der vorstehenden Ansprüche, wobei das metallische Material auf mindestens einem der folgenden Materialien basiert: TiN, TiC, TiSiN, TiSiCN, TiWN, TaN, TaCN.

9. Herstellungsverfahren einer Phasenwechselspeichervorrichtung (1), die einen Speicherpunkt (1000) umfasst, wobei das Verfahren die folgenden Schritte umfasst:
• Bereitstellen einer Einheit, die im mindestens Folgendes umfasst:
i. eine metallische Schicht (300) basierend auf einem metallischen Material und dazu bestimmt, ein Heizelement (3000) für den Speicherpunkt (1000) zu bilden, wobei die metallische Schicht (300) eine erste Hauptflanke (303) aufweist,
ii. eine erste Kapselungsschicht (400), die sich von der ersten Hauptflanke (303) der metallischen Schicht (300) erstreckt,
• Implantieren einer Spezies, die als erste dotierende Spezies bezeichnet wird, in einem Abschnitt (450), der als dotiert bezeichnet wird, der ersten Kapselungsschicht (400), wobei sich der dotierte Abschnitt (450) von der Hauptflanke (303) der metallischen Schicht (300) erstreckt,
• Implantieren einer Spezies, die als zweite dotierende Spezies bezeichnet wird, die bevorzugt mit der ersten dotierenden Spezies identisch ist, in der metallischen Schicht (300) durch die erste Kapselungsschicht (400) hindurch,
• Bilden gegen eine Fläche (301) der metallischen Schicht (300) einer Stapelung, die Folgendes umfasst:
i. eine Schicht, die als Speicherschicht (700) bezeichnet wird, basierend auf einem Phasenwechselmaterial, die thermisch mit der metallischen Schicht (300) derart gekoppelt ist, dass die durch Joule-Effekt erzeugte Wärme durch die metallische Schicht (300) zu der Speicherschicht (700) transferiert wird,
ii. eine obere Elektrode.

10. Verfahren nach dem vorstehenden Anspruch, wobei die erste dotierende Spezies aus den folgenden Spezies ausgewählt wird: Silizium, Kohlenstoff, Argon, Stickstoff, Sauerstoff, Xenon, Titan, Tantal, Wolfram, Germanium, Kobalt, Neon und deren Legierungen.

11. Verfahren nach einem der zwei vorstehenden Ansprüche, wobei die erste Kapselungsschicht (400) auf mindestens einem der folgenden Materialien basiert: SiN, SiCN, SiC.

12. Verfahren nach einem der drei vorstehenden Ansprüche, wobei die erste Kapselungsschicht (400) eine erste Hauptflanke (403) und eine zweite Hauptflanke (404) aufweist, die einander entgegengesetzt sind, wobei die zweite Hauptflanke (404) der ersten Hauptflanke (303) der metallischen Schicht (300) gegenüberliegt, wobei das Verfahren außerdem das Bilden einer zweiten Kapselungsschicht (500) gegen die erste Hauptflanke (403) der ersten Kapselungsschicht (400) umfasst, und wobei das Implantieren der zweiten dotierenden Spezies in der metallischen Schicht (300) durch die zweite Kapselungsschicht (500) erfolgt.

13. Verfahren nach einem der vier vorstehenden Ansprüche, wobei das Bereitstellen der Einheit die folgenden Schritte umfasst:
• Bereitstellen einer Trägerschicht (100), die eine obere Fläche (101) umfasst, die sich im Wesentlichen in einer Ebene parallel zu der Längsebene (XY) erstreckt,
• Bilden auf einem Abschnitt der oberen Fläche (101) der Trägerschicht (100) einer dielektrischen Schicht (200), wobei die dielektrische Schicht (200) eine Flanke (203) aufweist, die sich bevorzugt hauptsächlich in einer Ebene parallel zu der Querebene (YZ) erstreckt,
• Bilden der metallischen Schicht (300) mindestens gegen die Flanke (203) der Auflageschicht (200) und bevorzugt auf der oberen Fläche (101) der Trägerschicht (100).

14. Verfahren nach dem vorstehenden Anspruch, wobei die dielektrische Schicht (200) eine erste dielektrische Schicht (210) und eine zweite dielektrische Schicht (220) umfasst, wobei die zweite dielektrische Schicht (220) und die Trägerschicht (100) durch die erste dielektrische Schicht (210) getrennt werden, wobei das Verfahren außerdem einen Schritt zum Polieren eines Abschnitts der metallischen Schicht (300) und der zweiten dielektrischen Schicht (220) mit einem selektiven Stopp auf der zweiten dielektrischen Schicht (210) umfasst.

## Claims

1. Phase change memory device (1) comprising a memory point (1000), the memory point (1000) comprising:
• a metal layer (300) with the basis of a metal material and forming a heating element (3000),
• a memory layer (700) with the basis of a phase change material, the phase change material being configured such that the memory layer (700) passes selectively from a first resistive state (LRS) having a first resistivity to a second resistive state (HRS) having a second resistivity greater than the first resistivity (LRS),
• an upper electrode (800),
the heating element (3000) being intended to receive an electric current making it possible to produce heat by Joule effect and to transfer some of this heat to the memory layer (700) so as to make the memory layer (700) pass selectively from one from among the first resistive state (LRS) and the second resistive state (HRS), to the other from among the first resistive state (LRS) and the second resistive state (HRS),
the heating element (3000) has a first main flank (303) and a second main flank (304), opposite one another, the memory device further comprising a first encapsulation layer (400) extending from the first main flank (303) of the metal layer (300),
**characterised in that** the first encapsulation layer (400) has a so-called doped portion (450), having a doping with the basis of at least one species, called first doping species, the doped portion (450) extending from the first main flank (303) of the metal layer (300),
and **in that** the metal layer (300) has a doping with the basis of a second doping species, preferably identical to the first doping species.

2. Device (1) according to the preceding claim, wherein the concentration of doping species in the doped portion (450) is greater than or equal to 5.10²⁰ atoms/cm³, preferably greater than or equal to 1.10²¹ atoms/cm³.

3. Device (1) according to any one of the preceding claims, wherein the first encapsulation layer (400) has a thickness e₄₀₀ taken along a direction perpendicular to the first main flank (303) of the metal layer (300), the doped portion (450) extending over a thickness e₄₅₀ along this same direction within the first encapsulation layer (400), with e₄₅₀ ≥ 0.05*e₄₀₀, preferably e₄₅₀ ≥ 0.10*e₄₀₀.

4. Device (1) according to any one of the preceding claims, wherein the metal layer (300) has a thickness e₃₀₀ between its first main flank (303) and its second main flank (304), with e₃₀₀ ≤ 10nm.

5. Device (1) according to any one of the preceding claims, wherein the first main flank (303) of the metal layer (300) is integrally doped, preferably uniformly.

6. Device (1) according to any one of the preceding claims, further comprising a first dielectric layer (210) extending against the second main flank (304) of the metal layer (300), the first dielectric layer (210) having a so-called doped portion (215), having a doping with the basis of at least one species, called third doping species, preferably identical to the first doping species, the doped portion (215) of the first dielectric layer (210) extending from the second main flank (304) of the metal layer (300).

7. Device (1) according to any one of the preceding claims, wherein the first doping species is chosen from among the following species: silicon, carbon, argon, nitrogen, xenon, titanium, tantalum, tungsten, germanium, oxygen, cobalt, neon and their alloys.

8. Device (1) according to any one of the preceding claims, wherein the metal material is with the basis of at least one from among the following materials: TiN, TiC, TiSiN, TiSiCN, TiWN, TaN, TaCN.

9. Method for manufacturing a phase change memory device (1) comprising a memory point (1000), the method comprising the following steps:
• providing an assembly comprising at least:
i. a metal layer (300) with the basis of a metal material and intended to form a heating element (3000) for the memory point (1000), the metal layer (300) having a first main flank (303),
ii. a first encapsulation layer (400) extending from the first main flank (303) of the metal layer (300),
• implanting a species called first doping species in a so-called doped portion (450) of the first encapsulation layer (400), the doped portion (450) extending from the main flank (303) of the metal layer (300),
• implanting a species called second doping species, preferably identical to the first doping species, in the metal layer (300) through the first encapsulation layer (400),
• forming against a face (301) of the metal layer (300), a stack comprising:
i. a layer called memory layer (700) with the basis of a phase change material, thermally coupled with the metal layer (300) such that the heat produced by Joule effect by the metal layer (300) is transferred to the memory layer (700),
ii. an upper electrode.

10. Method according to the preceding claim, wherein the first doping species is chosen from among the following species: silicon, carbon, argon, nitrogen, oxygen, xenon, titanium, tantalum, tungsten, germanium, cobalt, neon and their alloys.

11. Method according to any one of the two preceding claims, wherein the first encapsulation layer (400) is with the basis of at least one from among the following materials: SiN, SiCN, SiC.

12. Method according to any one of the three preceding claims, wherein the first encapsulation layer (400) has a first main flank (403) and a second main flank (404) opposite one another, the second main flank (404) facing the first main flank (303) of the metal layer (300), the method further comprising the formation of a second encapsulation layer (500) against the first main flank (403) of the first encapsulation layer (400), and wherein the implantation of the second doping species in the metal layer (300) is performed through the second encapsulation layer (500).

13. Method according to any one of the four preceding claims, wherein the provision of the assembly comprises the following steps:
• providing a support layer (100) having an upper face (101) extending mainly into a plane parallel to the longitudinal plane (XY),
• forming a dielectric layer (200) on a portion of the upper face (101) of the support layer (100), the dielectric layer (200) having a flank (203) preferably extending into a plane parallel to the transverse plane (YZ),
• forming at least against the flank (203) of the support layer (200), and preferably on the upper face (101) of the support layer (100), the metal layer (300).

14. Method according to the preceding claim, wherein the dielectric layer (200) comprises a first dielectric layer (210) and a second dielectric layer (220), the second dielectric layer (220) and the support layer (100) being separated by the first dielectric layer (210), the method further comprising a step of polishing a portion of the metal layer (300) and of the second dielectric layer (220), with a selective stop on the first dielectric layer (210).
